# EUROPEAN PATENT APPLICATION

(11) **EP 4 258 353 A1**
(43) Date of publication of application: **11.10.2023**
(21) Application number: 23165550.7
(22) Date of filing: 30.03.2023
(51) Int. Cl.: H01L 25/075, H01L 33/08, H01L 33/62

(54) **PIXEL, DISPLAY DEVICE HAVING THE SAME, AND METHOD OF FABRICATING THE DISPLAY DEVICE**

(30) Priority: 04.04.2022 KR 20220041715
(71) Applicant: Samsung Display Co., Ltd., Yongin-si, Gyeonggi-do 17113 (KR)
(72) Inventor: LEE, Hyun Wook, 17113 Yongin-si (KR); LEE, Tae Hee, 17113 Yongin-si (KR); BAE, Sung Geun, 17113 Yongin-si (KR)
(74) Representative: Taor, Simon Edward William

(57) **Abstract**

A pixel includes: a substrate including emission area and a non-emission; a first conductive pattern, a second conductive pattern, and a third conductive pattern in the non-emission area; a via layer on the first to the third conductive patterns, and including a first contactor exposing one area of the first conductive pattern, a second contactor exposing one area of the second conductive pattern, and a third contactor exposing another area of the second conductive pattern; a first alignment electrode and a second alignment electrode on the via layer; a light emitting element between the first and second alignment electrodes; and a first electrode and a second electrode electrically connected to the light emitting element.

## Description

### CROSS-REFERENCE TO RELATED APPLICATION

The present application claims priority to and the benefit of Korean patent application number 10-2022-0041715, filed on April 04, 2022.

### BACKGROUND

### 1. Field

Various embodiments of the present disclosure relate to a pixel, a display device including the pixel, and a method of fabricating the display device.

### 2. Description of Related Art

Recently, as interest in information display increases, research and development on display devices have been continuously conducted.

### SUMMARY

Various embodiments of the present disclosure are directed to a pixel having improved reliability, and a display device including the pixel.

Furthermore, various embodiments of the present disclosure are directed to a method of fabricating the display device.

One or more embodiments of the present disclosure may provide a pixel including: a substrate including an emission area and a non-emission area; a first conductive pattern, a second conductive pattern, and a third conductive pattern in the non-emission area and spaced from each other; a via layer on the first to the third conductive patterns, and including a first contactor exposing one area of the first conductive pattern, a second contactor exposing one area of the second conductive pattern, and a third contactor exposing another area of the second conductive pattern; a first alignment electrode and a second alignment electrode on the via layer, and spaced from each other; a light emitting element between the first alignment electrode and the second alignment electrode; and a first electrode and a second electrode spaced from each other, and electrically connected to the light emitting element.

In at least the non-emission area, at least one of the first and the second electrodes may directly contact the one area of the first conductive pattern through the first contactor. At least one of the first and the second alignment electrodes may directly contact the one area of the second conductive pattern through the second contactor.

In one or more embodiments, the pixel may further include: a passivation layer between the via layer and the first and second conductive patterns; a first insulating layer between the light emitting element and the first and the second alignment electrodes; a second insulating layer on the light emitting element, and exposing first and second ends of the light emitting element; and a third insulating layer on the second insulating layer. The first insulating layer may include a first through hole corresponding to the first contactor, and a second through hole corresponding to the third contactor.

In one or more embodiments, an inclination angle of each of opposite side surfaces of the via layer that oppose each other with the first contactor located therebetween may be same as an inclination angle of each of opposite side surfaces of the first insulating layer that oppose each other with the first through hole located therebetween. An inclination angle of each of opposite side surfaces of the via layer that oppose each other with the third contactor located therebetween may be same as an inclination angle of each of opposite side surfaces of the first insulating layer that oppose each other with the second through hole located therebetween.

In one or more embodiments, the passivation layer may include a first contact hole overlapping the first contactor and exposing the one area of the first conductive pattern, a second contact hole overlapping the second contactor and exposing the one area of the second conductive pattern, and a third contact hole overlapping the third contactor and exposing the another area of the second conductive pattern. The second insulating layer may include a first opening corresponding to the first contact hole, and a second opening corresponding to the third contact hole. The third insulating layer may include a first via hole corresponding to the first opening, and a second via hole corresponding to the second opening.

In one or more embodiments, the first electrode may directly contact the one area of the first conductive pattern through the first via hole of the third insulating layer, the first opening of the second insulating layer, the first through hole of the first insulating layer, the first contactor of the via layer, and the first contact hole of the passivation layer. The second alignment electrode may directly contact the one area of the second conductive pattern through the second contactor of the via layer and the second contact hole of the passivation layer.

In one or more embodiments, the pixel may further include: at least one transistor located between the substrate and the passivation layer, and electrically connected to the light emitting element; a capacitor between the substrate and the passivation layer, and including a first storage electrode connected to a gate electrode of the transistor, and a second storage electrode electrically connected to the light emitting element; a first power line between the substrate and the passivation layer, and configured to receive a voltage of a first driving power supply; and a second power line spaced from the first power line, and configured to receive a voltage of a second driving power supply different from the first driving power supply.

In one or more embodiments, the first conductive pattern may include the second storage electrode. The second conductive pattern may include the second power line.

In one or more embodiments, the via layer may further include a fourth contactor exposing one area of the third conductive pattern. The passivation layer further includes a fourth contact hole corresponding to the fourth contactor and exposing the one area of the third conductive pattern.

In one or more embodiments, the second electrode may directly contact the another area of the second conductive pattern through the second via hole of the third insulating layer, the second opening of the second insulating layer, the second through hole of the first insulating layer, the third contactor of the via layer, and the third contact hole of the passivation layer. The first alignment electrode may directly contact the one area of the third conductive pattern through the fourth contactor of the via layer and the fourth contact hole of the passivation layer.

In one or more embodiments, the third conductive pattern may include the first power line.

In one or more embodiments, the pixel may further include a first bank in the non-emission area, and including an opening corresponding to the emission area. The second and the fourth contactors of the via layer may overlap the first bank, and the first and the third contactors of the via layer may not overlap the first bank.

In one or more embodiments, the pixel may further include an intermediate electrode spaced from the first and the second electrodes.

In one or more embodiments, the light emitting element may include: a first light emitting element between a first side of the first alignment electrode and the second alignment electrode, and including a first end electrically connected to the first electrode, and a second end electrically connected to the intermediate electrode; and a second light emitting element between a second side of the first alignment electrode and the second alignment electrode, and including a first end electrically connected to the intermediate electrode, and a second end electrically connected to the second electrode.

In one or more embodiments, the pixel may further include: a second bank on a first bank in the non-emission area; a color conversion layer over the first and the second light emitting elements in the emission area, and configured to convert a first color of light emitted from the first and the second light emitting elements to a second color of light; and a color filter on the color conversion layer and configured to allow the second color of light to selectively pass therethrough.

In one or more embodiments, the opposite side surfaces of the via layer that oppose each other with the first contactor located therebetween may be located more inside of the substrate than the opposite side surfaces of the first insulating layer that oppose each other with the first through hole located therebetween. The opposite side surfaces of the via layer and the opposite side surfaces of the first insulating layer may be covered by the first bank.

An embodiment of the present disclosure may provide a display device including: a substrate including a display area, and a non-display area, the non-display area including a pad area; a plurality of pixels in the display area, and each of the plurality of pixels including an emission area and a non-emission area; and a pad in the pad area, and electrically connected with each of the plurality of pixels. Each of the plurality of pixels may include: a first conductive pattern, a second conductive pattern, and a third conductive pattern in the non-emission area and spaced from each other; a passivation layer on the first to the third conductive patterns, and including a first contact hole exposing one area of the first conductive pattern, a second contact hole exposing one area of the second conductive pattern, and a third contact hole exposing another area of the second conductive pattern; a via layer on the passivation layer, and including a first contactor overlapping the first contact hole, a second contactor overlapping the second contact hole, and a third contactor overlapping the third contact hole; a first alignment electrode and a second alignment electrode on the via layer, and spaced from each other; a first insulating layer on the first and the second alignment electrodes, and including a first through hole corresponding to the first contactor, and a second through hole corresponding to the third contactor; light emitting elements on the first insulating layer between the first alignment electrode and the second alignment electrode; a second insulating layer on the light emitting elements and exposing opposite ends of each of the light emitting elements, and including a first opening overlapping the first through hole and the first contactor, and a second opening overlapping the second through hole and the third contactor; an intermediate electrode on the second insulating layer and electrically connected to the light emitting elements; a third insulating layer on the intermediate electrode, and including a first via hole corresponding to the first opening, and a second via hole corresponding to the second opening; and a first electrode and a second electrode on the third insulating layer at positions spaced from each other, and electrically connected to the light emitting elements.

In one or more embodiments, in at least the non-emission area, the first electrode may directly contact the one area of the first conductive pattern through the first via hole, the first opening, the first through hole, the first contactor, and the first contact hole. In at least the non-emission area, the second alignment electrode may directly contact the one area of the second conductive pattern through the second contactor and the second contact hole.

In one or more embodiments, the pad may include: a first pad electrode on the substrate; the passivation layer on the first pad electrode, and including a first pad electrode contact hole exposing one area of the first pad electrode; the third insulating layer on the passivation layer, and including a second pad electrode contact hole corresponding to the first pad electrode contact hole; and a second pad electrode on the third insulating layer, and directly contacting the first pad electrode through the first pad electrode contact hole and the second pad electrode contact hole.

The first pad electrode may be at a same layer as the first to the third conductive patterns, and may include a same material as the first to the third conductive patterns. The second pad electrode may be at a same layer as the first and the second electrodes, and may include a same material as the first and the second electrodes.

The pad may include: a first pad electrode on the substrate; the passivation layer on the first pad electrode, and including a first pad electrode contact hole exposing one area of the first pad electrode; the first insulating layer on the passivation layer, and including a second pad electrode contact hole corresponding to the first pad electrode contact hole; a second pad electrode on the first insulating layer, and directly contacting the first pad electrode through the first pad electrode contact hole and the second pad electrode contact hole; and the third insulating layer on the second pad electrode, and including a third pad electrode contact hole exposing one area of the second pad electrode.

In one or more embodiments, the first pad electrode may be at a same layer as the first to the third conductive patterns, and may include a same as material of the first to the third conductive patterns. The second pad electrode may be at a same layer as the intermediate electrode, and may include a same material as the intermediate electrode.

The display device may be fabricated by a method including: forming a first conductive pattern and a second conductive pattern spaced from each other on a substrate, and forming a passivation layer on the first and the second conductive patterns; forming a via material layer on the passivation layer, the via material layer including a second contactor exposing one area of the passivation on the second conductive pattern, and a stepped portion corresponding to the first conductive pattern; exposing a portion of the second conductive pattern by removing the one area of the passivation layer by a dry etching method; forming, on the via material layer, a first alignment electrode and a second alignment electrode spaced from each other; forming, on the first and the second alignment electrodes, a first insulating layer including a first through hole exposing the stepped portion; forming, by removing the stepped portion by an ashing method, a via layer including a first contactor exposing the passivation layer located under the stepped portion; forming a bank on the via layer; aligning light emitting elements on the first insulating layer between the first alignment electrode and the second alignment electrode; forming, on the light emitting elements and the first insulating layer, a second insulating layer exposing opposite ends of each of the light emitting elements; forming, on the second insulating layer, an intermediate electrode electrically connected to the light emitting elements; forming, on the intermediate electrode, a third insulating layer covering the intermediate electrode; and forming, on the third insulating layer, a first electrode and a second electrode spaced from each other and electrically connected to the light emitting elements.

According to an aspect, there is provided a pixel as set out in claim 1. Additional features are set out in claims 2 to 11. According to an aspect, there is provided a display device as set out in claim 12. Additional features are set out in claims 13 and 14. According to an aspect, there is provided a method as set out in claim 15.

### BRIEF DESCRIPTION OF THE DRAWINGS

The above and other embodiments and features of the present disclosure will become more apparent by describing embodiments thereof with reference to the attached drawings, in which:
FIG. 1 is a perspective view schematically illustrating a light emitting element in accordance with one or more embodiments;
FIG. 2 is a schematic cross-sectional view illustrating the light emitting element of FIG. 1;
FIG. 3 is a plan view schematically illustrating a display device in accordance with one or more embodiments;
FIG. 4 is a schematic cross-sectional view of a display panel illustrated in FIG. 3;
FIG. 5 is a schematic circuit diagram illustrating an electrical connection relationship of components included in a pixel illustrated in FIG. 3;
FIG. 6 is a plan view schematically illustrating a display element layer of the pixel illustrated in FIG. 3;
FIG. 7A is a schematic cross-sectional view taken along the line II-II' of FIG. 6;
FIG. 7B is a schematic enlarged view of a portion EA1 of FIG. 7A;
FIGS. 8 to 10 are schematic cross-sectional views taken along the line III-III' of FIG. 6;
FIG. 11A shows schematic cross-sectional views taken along the line IV-IV' and line V-V' of FIG. 6;
FIG. 11B is a schematic enlarged view of a portion EA2 of FIG. 11A;
FIG. 12A and 12B are schematic cross-sectional views taken along the line I-I' of FIG. 3;
FIGS. 13 to 24 are views sequentially illustrating a method of fabricating the display device in accordance with one or more embodiments, and are schematic cross-sectional views taken along the line I-I' of FIG. 3 and the line II-II' of FIG. 6;
FIG. 25 is a schematic sectional view illustrating a pixel in accordance with one or more embodiments, and is a schematic cross-sectional view taken along the line II-II' of FIG. 6;
FIG. 26 is a plan view schematically illustrating a pixel area including an optical layer in the pixel illustrated in FIG. 3; and
FIGS. 27 and 28 are schematic cross-sectional views taken along the line VI-VI' of FIG. 26.

### DETAILED DESCRIPTION

As the present disclosure allows for various changes and numerous embodiments, particular embodiments will be illustrated in the drawings and described in detail in the written description. However, this is not intended to limit the present disclosure to particular modes of practice, and it is to be appreciated that all changes, equivalents, and substitutes that do not depart from the technical scope of the present disclosure are encompassed in the present disclosure.

Throughout the present disclosure, like reference numerals refer to like parts throughout the various figures and embodiments of the present disclosure. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element can be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Embodiments and required details of the present disclosure are described with reference to the accompanying drawings in order to describe the present disclosure in detail so that those having ordinary knowledge in the technical field to which the present disclosure pertains can easily practice the present disclosure. Furthermore, a singular form may include a plural form as long as it is not specifically mentioned in a sentence.

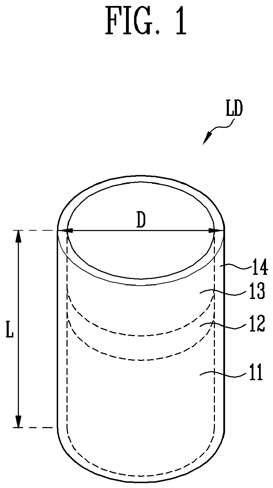

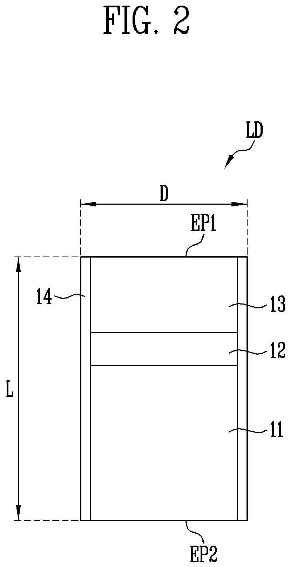

FIG. 1 is a perspective view schematically illustrating a light emitting element LD in accordance with one or more embodiments. FIG. 2 is a schematic cross-sectional view illustrating the light emitting element LD of FIG. 1.

Referring to FIGS. 1 and 2, in one or more embodiments, the type and/or shape of the light emitting element LD is not limited to the embodiment illustrated in FIGS. 1 and 2.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stack pattern") formed by successively stacking the first semiconductor layer 11, the active layer 12, and the second semiconductor layer 13.

The light emitting element LD may be formed in a shape extending in one direction. If the direction in which the light emitting element LD extends is defined as a longitudinal direction, the light emitting element LD may have a first end EP1 and a second end EP2 that are opposite to each other in the longitudinal direction. One semiconductor layer of the first semiconductor layer 11 and the second semiconductor layer 13 may be disposed on the first end EP1 of the light emitting element LD, and the other semiconductor layer of the first semiconductor layer 11 and the second semiconductor layer 13 may be disposed on the second end EP2 of the light emitting element LD. For example, the second semiconductor layer 13 may be disposed on the first end EP1 of the light emitting element LD, and the first semiconductor layer 11 may be disposed on the second end EP2 of the light emitting element LD.

The light emitting element LD may have various shapes. For example, as illustrated in FIG. 1, the light emitting element LD may have a rod-like shape, a bar-like shape, or a pillar-like shape which is long in the longitudinal direction (i.e., to have an aspect ratio greater than 1). Alternatively, the light emitting element LD may have a rod-like shape, a bar-like shape, or a pillar-like shape which is short in the longitudinal direction (or has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from nano scale (or nanometer scale) to micro scale (or micrometer scale).

In case that the light emitting element LD is long (i.e., to have an aspect ratio greater than 1) in the longitudinal direction, the diameter D of the light emitting element LD may approximately range from about 0.5 µm to about 6 µm, and the length L thereof may approximately range from about 1 µm to about 10 µm. However, the diameter D and the length L of the light emitting element LD of embodiments are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. For instance, the first semiconductor layer 11 may include an n-type semiconductor layer which includes any one semiconductor material of InAlGaN, GaN, AlGaN, InGaN, AlN, and InN and is doped with a first conductive dopant (or an n-type dopant) such as Si, Ge, or Sn. However, the constituent material of the first semiconductor layer 11 of embodiments is not limited to thereto, and various other materials may be used to form the first conductive semiconductor layer 11. The first semiconductor layer 11 may include, with regard to the longitudinal direction of the light emitting element LD, a first surface that contacts the active layer 12, and a second surface exposed to the outside.

The active layer 12 (or an emission layer) may be located on the first semiconductor layer 11, and may have a single or multiple quantum well structure. For example, in case that the active layer 12 has a multiple quantum well structure, the active layer 12 may be formed by periodically and repeatedly stacking a barrier layer, a strain reinforcing layer, and a well layer, which are provided as one unit. The strain reinforcing layer may have a lattice constant that is less than that of the barrier layer so that strain, e.g., compressive strain, to be applied to the well layer can be further reinforced. However, the structure of the active layer 12 is not limited to that of the foregoing embodiment.

The active layer 12 may emit light having a wavelength ranging from about 400 nm to about 900 nm, and have a double hetero structure. In one or more embodiments, a clad layer doped with a conductive dopant may be formed over and/or under the active layer 12 in the longitudinal direction of the light emitting element LD. For example, the clad layer may be formed of an AlGaN layer or an InAlGaN layer. In one or more embodiments, material such as AlGaN or InAlGaN may be used to form the active layer 12, and various other materials may be used to form the active layer 12. The active layer 12 may include a first surface that contacts the first semiconductor layer 11, and a second surface that contacts the second semiconductor layer 13.

If an electric field having a certain voltage or more is applied between the opposite ends of the light emitting element LD, the light emitting element LD may emit light by coupling of electron-hole pairs in the active layer 12. Because light emission of the light emitting element LD can be controlled based on the foregoing principle, the light emitting element LD may be used as a light source (or a light emitting source) of various light emitting devices as well as a pixel of a display device.

The second semiconductor layer 13 may be located on the second surface of the active layer 12, and may include a semiconductor layer of a type that is different from that of the first semiconductor layer 11. For example, the second semiconductor layer 13 may include at least one p-type semiconductor layer. For instance, the second semiconductor layer 13 may include a p-type semiconductor layer that includes any one semiconductor material from among InAlGaN, GaN, AlGaN, InGaN, AlN, and InN, and may be doped with a second conductive dopant (or a p-type dopant) such as Mg, Zn, Ca, Sr, or Ba. However, the material for forming the second semiconductor layer 13 of embodiments is not limited thereto, and various other materials may be used to form the second semiconductor layer 13. The second semiconductor layer 13 may include, with regard to the longitudinal direction of the light emitting element LD, a first surface that contacts the second surface of the active layer 12, and a second surface exposed to the outside.

In one or more embodiments, the first semiconductor layer 11 and the second semiconductor layer 13 may have different thicknesses in the longitudinal direction of the light emitting element LD. For example, the first semiconductor layer 11 may have a thickness that is greater than that of the second semiconductor layer 13 in the longitudinal direction of the light emitting element LD. Hence, the active layer 12 of the light emitting element LD may be located at a position closer to the upper surface of the second semiconductor layer 13 than to the lower surface of the first semiconductor layer 11.

Although the first semiconductor layer 11 and the second semiconductor layer 13 are formed of a single layer, embodiments of the present disclosure are not limited thereto. In one or more embodiments, depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer of which a lattice structure is located between other semiconductor layers so that the strain relief layer can function as a buffer layer to reduce a difference in lattice constant. Although the TSBR layer may be formed of a p-type semiconductor layer such as p-GaInP, p-AlInP, or p-AlGaInP, embodiments of the present disclosure are not limited thereto.

In one or more embodiments, the light emitting element LD may further include a contact electrode (hereinafter referred to as 'first contact electrode') located over the second semiconductor layer 13, as well as including the first semiconductor layer 11, the active layer 12, and the second semiconductor layer 13. Furthermore, in one or more embodiments, the light emitting element LD may further include another contact electrode (hereinafter referred to as 'second contact electrode') located on one end of the first semiconductor layer 11.

Each of the first and second contact electrodes may be an ohmic contact electrode, but embodiments of the present disclosure are not limited thereto. In one or more embodiments, each of the first and second contact electrodes may be a Schottky contact electrode. The first and second contact electrodes may include conductive material. For example, the first and second contact electrodes may include opaque metal such as chrome (Cr), titanium (Ti), aluminum (Al), gold (Au), nickel (Ni), and oxides or alloys thereof, which are used alone or in combination, but embodiments of the present disclosure are not limited thereto. In one or more embodiments, the first and second contact electrodes may also include transparent conductive oxides such as indium tin oxide (ITO), indium zinc oxide (IZO), zinc oxide (ZnOₓ), indium gallium zinc oxide (IGZO), and indium tin zinc oxide (ITZO). Here, the zinc oxide (ZnOₓ) may be zinc oxide (ZnO) and/or zinc peroxide (ZnO₂).

Materials included in the first and second contact electrodes may be equal to or different from each other. The first and second contact electrodes may be substantially transparent or translucent. Therefore, light generated from the light emitting element LD may pass through each of the first and second contact electrodes and then be emitted outside the light emitting element LD. In one or more embodiments, in case that light generated from the light emitting element LD is emitted outside the light emitting element LD through an area other than the opposite ends of the light emitting element LD rather than passing through the first and second contact electrodes, the first and second contact electrodes may include opaque metal.

In one or more embodiments, the light emitting element LD may further include an insulating layer 14. However, in some embodiments, the insulating layer 14 may be omitted, or may be provided to cover only some of the first semiconductor layer 11, the active layer 12, and the second semiconductor layer 13.

The insulating layer 14 may prevent the active layer 12 from short-circuiting due to contacting conductive material other than the first and second semiconductor layers 11 and 13. Furthermore, the insulating layer 14 may reduce or minimize a surface defect of the light emitting element LD, thus enhancing the lifetime and emission efficiency of the light emitting element LD. In case that a plurality of light emitting elements LD are located in close contact with each other, the insulating layer 14 may reduce or prevent the likelihood of an undesired short-circuit from occurring between the light emitting elements LD. The presence or non-presence of the insulating layer 14 is not limited, so long as the active layer 12 can be prevented from short-circuiting with external conductive material.

The insulating layer 14 may be provided to enclose an overall outer surface (e.g., outer peripheral or circumferential surface) of the emission stack including the first semiconductor layer 11, the active layer 12, and the second semiconductor layer 13.

Although in the foregoing embodiment the insulating layer 14 has been described as enclosing the entirety of the respective outer surfaces (e.g., outer peripheral or circumferential surfaces) of the first semiconductor layer 11, the active layer 12, and the second semiconductor layer 13, embodiments of the present disclosure are not limited thereto. In one or more embodiments, in case that the light emitting element LD includes the first contact electrode, the insulating layer 14 may enclose the entirety of the respective outer surfaces (e.g., outer peripheral or circumferential surfaces) of the first semiconductor layer 11, the active layer 12, the second semiconductor layer 13, and the first contact electrode. In one or more embodiments, the insulating layer 14 may not enclose the entirety of the outer surface (e.g., outer peripheral or circumferential surface) of the first semiconductor layer 11, or may enclose only a portion of the outer surface (e.g., outer peripheral or circumferential surface) of the first semiconductor layer 11 without enclosing the other portion of the outer surface (e.g., outer peripheral or circumferential surface) of the first semiconductor layer 11. Furthermore, in one or more embodiments, in case that the first contact electrode is disposed on a first end of the light emitting element LD and the second contact electrode is disposed on a second end of the light emitting element LD, the insulating layer 14 may allow at least one area of each of the first and second contact electrodes to be exposed.

The insulating layer 14 may include transparent insulating material. For example, the insulating layer 14 may include one or more insulating materials selected from the group constituting of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanstrontium oxide (SrTiOₓ), cobalt oxide (CoₓO_{y}), magnesium oxide (MgO), zinc oxide (ZnOₓ), ruthenium Oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InxOy:H, niobium oxide (NbₓO_{y}), magnesium fluoride (MgFₓ), aluminum fluoride (AlFₓ), an alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN). However, embodiments of the present disclosure are not limited thereto, and various other suitable insulating materials may be used as the material of the insulating layer 14.

The insulating layer 14 may be provided in the form of a single layer or in the form of multiple layers including double layers. For example, in case that the insulating layer 14 is formed of a double layer structure including a first layer and a second layer that are successively stacked, the first layer and the second layer may be made of different materials (or substances) and may be formed through different processes. In one or more embodiments, the first layer and the second layer may include the same material, and may be formed through a successive process.

In one or more embodiments, the light emitting element LD may be implemented as a light emitting pattern having a core-shell structure. In this case, the first semiconductor layer 11 may be located in a core of the light emitting element LD, i.e., a central portion of the light emitting element LD. The active layer 12 may be provided and/or formed to enclose the outer surface (e.g., outer peripheral or circumferential surface) of the first semiconductor layer 11. The second semiconductor layer 13 may be provided and/or formed to enclose the active layer 12. Furthermore, the light emitting element LD may further include a contact electrode formed to enclose at least one side of the second semiconductor layer 13. In one or more embodiments, the light emitting element LD may further include an insulating layer 14 that is provided on the outer surface (e.g., outer peripheral or circumferential surface) of the light emitting pattern having a core-shell structure, and that has transparent insulating material. The light emitting element LD implemented as the light emitting pattern having the core-shell structure may be manufactured in a growth manner.

The light emitting element LD may be employed as a light emitting source (or a light source) for various display devices. The light emitting element LD may be fabricated through a surface treatment process. For example, the light emitting element LD may be surface-treated so that, when a plurality of light emitting elements LD are mixed with a fluidic solution (or solvent) and then supplied to each pixel area (e.g., an emission area of each pixel or an emission area of each sub-pixel), the light emitting elements LD can be evenly distributed rather than unevenly aggregating in the solution.

An emission component (or a light emitting device or a light emitting unit) including the light emitting element LD described above may be used not only in a display device but also in various types of electronic devices each of which requires a light source. For instance, in case that a plurality of light emitting elements LD are located in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices such as a lighting device, which requires or suitably uses a light source.

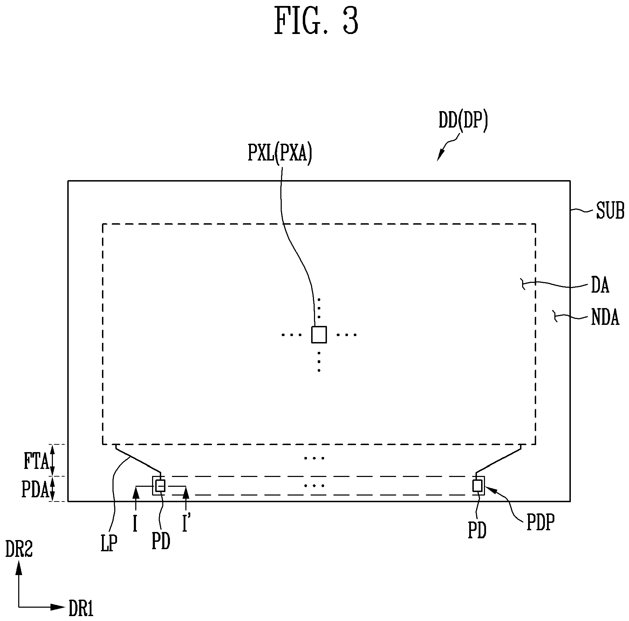

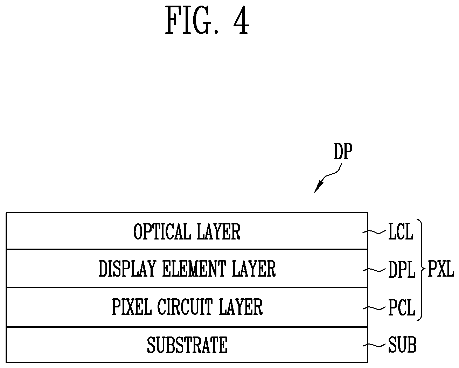

FIG. 3 is a plan view schematically illustrating a display device DD in accordance with one or more embodiments. FIG. 4 is a schematic cross-sectional view of a display panel DP illustrated in FIG. 3.

In FIGS. 3 and 4, for the convenience sake, there is schematically illustrated the display device DD, particularly, the structure of a display panel DP provided in the display device DD, centered on a display area DA in which an image is displayed.

If the display device DD is an electronic device having a display surface on at least one surface thereof, e.g., a smartphone, a television, a tablet personal computer (PC), a mobile phone, a video phone, an electronic-book reader, a desktop PC, a laptop PC, a netbook computer, a workstation, a server, a personal digital assistant (PDA), a portable multimedia player (PMP), an MP3 player, a medical appliance, a camera, or a wearable device, the present disclosure may be applied to the display device DD.

Referring to FIGS. 1 to 4, the display device DD may include a substrate SUB, pixels PXL provided (or disposed) on the substrate SUB and each including at least one light emitting element LD, a driver provided (or disposed) on the substrate SUB and configured to drive the pixels PXL, and a line component provided to electrically connect the pixels PXL with the driver.

The display device DD may be classified as a passive matrix type display device or an active matrix type display device according to a method of driving the light emitting element LD. For example, in case that the display device DD is implemented as an active matrix type, each of the pixels PXL may include a driving transistor configured to control the amount of current to be supplied to the light emitting element LD, and a switching transistor configured to transmit data signals to the driving transistor.

The display device DD may be provided in various forms, for example, in the form of a rectangular plate having two pairs of parallel sides, but embodiments of the present disclosure are not limited thereto. In case that the display device DD is provided in the form of a rectangular plate, one of the two pairs of sides thereof may be longer than the other thereof. For convenience of description, there is illustrated the case where the display device DD has a rectangular shape with a pair of long sides and a pair of short sides. A direction in which the short sides extend is indicated by a second direction DR2, and a direction in which the long sides extend is indicated by a first direction DR1. In the display device DD provided in a rectangular planar shape, each corner on which one long side and one short side contact (or meet) each other may have a round shape.

The display panel DP may include a substrate SUB, and a pixel circuit layer PCL, a display element layer DPL, and an optical layer LCL that are successively disposed on the substrate SUB.

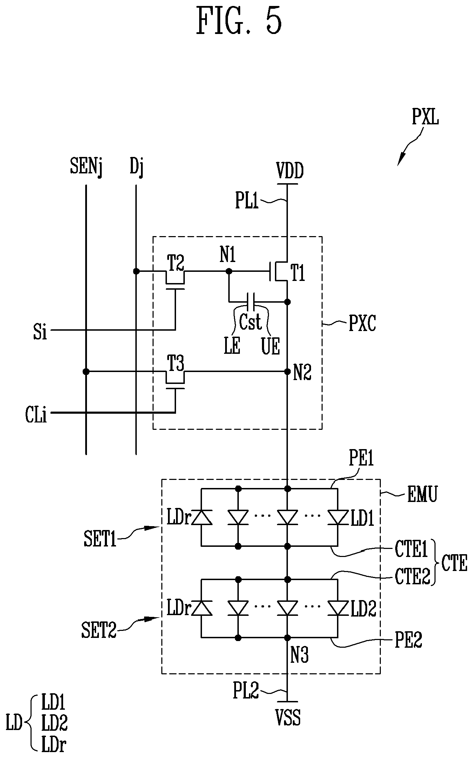

A pixel circuit (refer to "PXC" of FIG. 5) which is provided on the substrate SUB and includes a plurality of transistors and signal lines connected to the transistors may be disposed in the pixel circuit layer PCL. For example, each transistor has a structure in which a semiconductor layer, a gate electrode, a first terminal, and a second terminal are successively stacked with insulating layers interposed therebetween. The semiconductor layer may include amorphous silicon, polysilicon, low-temperature polysilicon, and an organic semiconductor, and/or an oxide semiconductor. Although the gate electrode, the first terminal (or the source electrode), and the second terminal (or the drain electrode) each may include one of aluminum (Al), copper (Cu), titanium (Ti), and molybdenum (Mo), embodiments of the present disclosure are not limited thereto. In addition, the pixel circuit layer PCL may include at least one insulating layer.

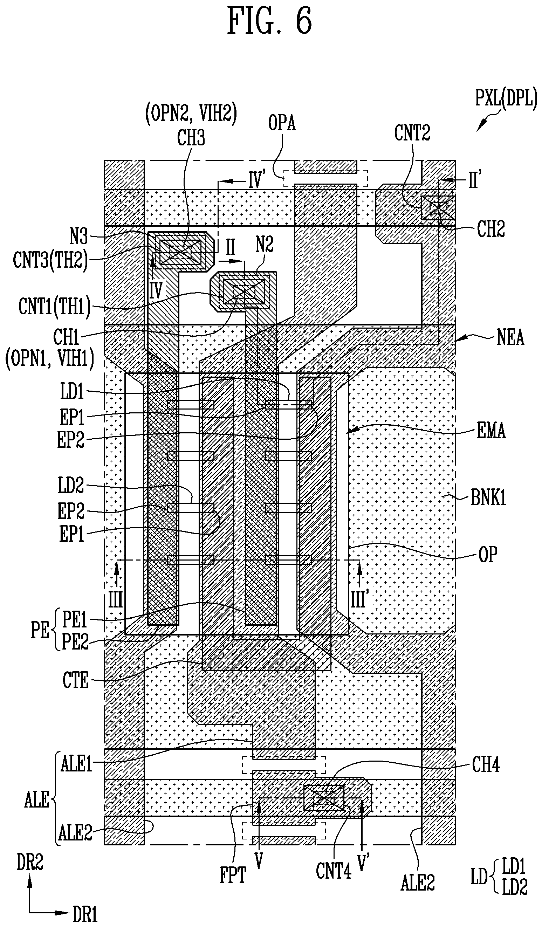

The display element layer DPL may be disposed on the pixel circuit layer PCL. An emission component (refer to "EMU" of FIG. 5) including a light emitting element LD configured to emit light may be disposed in the display element layer DPL. Detailed explanation of the display element layer DPL will be made with reference to FIGS. 6 to 11B.

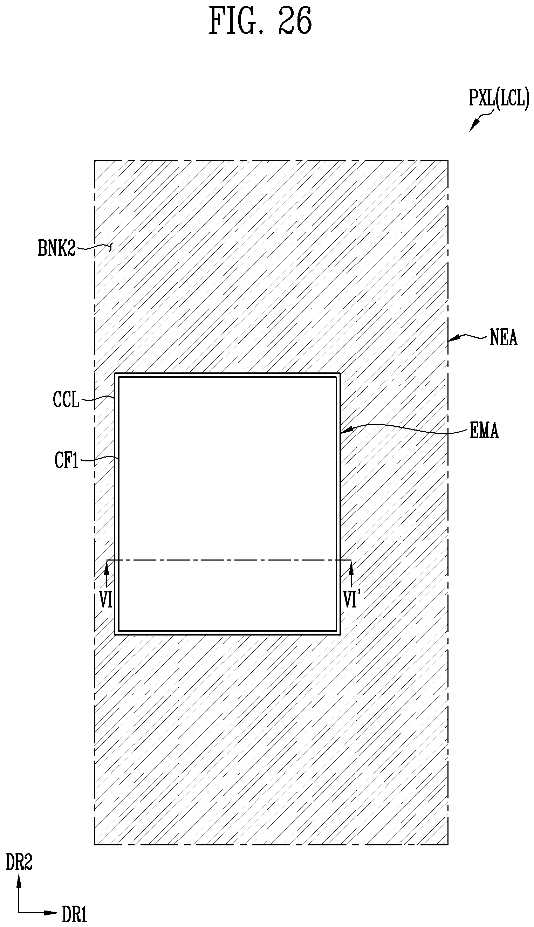

The optical layer LCL may be selectively disposed on the display element layer DPL. The optical layer LCL may convert light emitted from the light emitting element LD to light having excellent color reproducibility and emit the converted light, thus enhancing the light output efficiency of each pixel PXL. The optical layer LCL may include a color conversion layer and a color filter. Detailed descriptions pertaining to the optical layer LCL will be made with reference to FIGS. 26 to 28.

The pixels PXL may be arranged in a matrix form in rows extending in the first direction DR1 and columns extending in the second direction DR2 intersecting the first direction DR1. However, the arrangement of the pixels PXL is not limited to a particular arrangement. In other words, the pixels PXL may be arranged in various forms. Although each of the pixels PXL has been illustrated as having a rectangular shape, embodiments of the present disclosure are not limited thereto. The pixel PXL may have various shapes. Furthermore, in case that a plurality of pixels PXL are provided, the pixels PXL may have different surface areas (or different sizes). For example, in case that pixels PXL emit different colors of light, the pixels PXL may have different surface areas (or different sizes) or different shapes by colors.

Each of the pixels PXL may include at least one or more light emitting elements LD configured to be driven in response to a corresponding scan signal and a corresponding data signal. The light emitting element LD may have a small size ranging from the nano scale (or the nanometer scale) to the micro scale (the micrometer scale) and may be connected in parallel to light emitting elements LD disposed adjacent thereto, but embodiments of the present disclosure are not limited thereto. The light emitting element LD may form a light source of each pixel PXL.

Each of the pixels PXL may include at least one light source, e.g., the light emitting element LD illustrated in FIG. 1, which is driven by a suitable signal (e.g., a set or predetermined signal, such as, for example, a scan signal and a data signal) and/or a suitable power supply (e.g., a set or predetermined power supply, such as, for example, a first driving power supply and a second driving power supply). However, the type of the light emitting element LD that may be used as a light source of each pixel PXL of embodiments is not limited thereto.

The substrate SUB may include transparent insulating material to allow light transmission. The substrate SUB may be a rigid substrate or a flexible substrate.

The substrate SUB may include a display area DA and a non-display area NDA around an edge or periphery of the display area DA. For example, the substrate SUB may include the display area DA including a plurality of pixel areas PXA on which the respective pixels PXL are disposed, and the non-display area NDA disposed around the perimeter of the display area DA (or adjacent to the display area DA). The display area DA may be an area in which the pixels PXL are provided and an image is thus displayed. The non-display area NDA may be an area in which the pixels PXL are not provided, and may be an area in which no image is displayed.

The non-display area NDA may be provided on at least one side of the display area DA. The non-display area NDA may enclose the perimeter (or edges) of the display area DA. Portions of the line component connected to the pixels PXL, and the driver connected to the line component and configured to drive the pixels PXL may be provided in the non-display area NDA.

The non-display area NDA may be an area in which certain lines (e.g., fanout lines LP), pads PD, and/or an internal circuit that are electrically connected with the pixels PXL to drive the pixels PXL are provided.

In one or more embodiments, the non-display area NDA may include a fanout area FTA and a pad area PDA.

The pad area PDA may be one area of the non-display area NDA in which the pad component PDP is located, and may be disposed most adjacent to a perimeter (or an edge) of the non-display area NDA. The fanout area FTA may be another area of the non-display area NDA in which the fanout lines LP that are portions of the line component are located, and may be disposed adjacent to the display area DA in the non-display area NDA. For example, the fan-out area FTA may be one area of the non-display area NDA that is disposed between the pad area PDA and the display area DA. In one or more embodiments, the non-display area NDA may include an antistatic circuit area in which there is disposed an antistatic circuit that is electrically connected to signal lines disposed in the display area DA and configured to prevent static electricity from occurring. The antistatic circuit area may be one area of the non-display area NDA between the display area DA and the fanout area FTA. In one or more embodiments, the non-display area NDA may include an area where a demultiplexer is located.

The pad component PDP may be disposed in the pad area PDA. The fanout lines LP, which are portions of the line component, may be disposed in the fanout area FTA.

The fanout lines LP may be electrically connected to the pixels PXL so that certain signals applied from the driver may be transmitted to the pixels PXL. The fanout lines LP may be disposed in the fanout area FTA and electrically connect the driver to the pixels PXL.

The pad component PDP may include a plurality of pads PD. The pads PD may supply (or transmit) driving power voltages and signals for driving the pixels PXL provided in the display area DA and/or the internal circuits. In one or more embodiments, in the case in which the driver is mounted in the non-display area NDA of the substrate SUB, the pad component PDP may overlap output pads of the drivers and may be supplied with signals outputted from the driver.

FIG. 5 is a schematic circuit diagram illustrating an electrical connection relationship of components included in the pixel PXL illustrated in FIG. 3.

For example, FIG. 5 illustrates the electrical connection relationship of components included in the pixel PXL that may be employed in an active matrix type display device in accordance with one or more embodiments. Here, the connection relationship of the components of each pixel PXL of embodiments is not limited thereto.

Referring to FIGS. 1 to 5, the pixel PXL may include an emission component EMU (or an emission unit) configured to generate light having a luminance corresponding to a data signal. Furthermore, the pixel PXL may selectively further include a pixel circuit PXC configured to drive the emission component EMU.

In one or more embodiments, the emission component EMU may include a plurality of light emitting elements LD connected in parallel between a first power line PL1 that is electrically connected to a first driving power supply VDD and configured to receive a voltage of the first driving power supply VDD, and a second power line PL2 that is electrically connected to a second driving power supply VSS and configured to receive a voltage of the second driving power supply VSS. For example, the emission component EMU may include a first electrode PE1 (or a first pixel electrode) electrically connected to the first driving power supply VDD via the pixel circuit PXC and the first power line PL1, a second electrode PE2 (or a second pixel electrode) electrically connected to the second driving power supply VSS through the second power line PL2 and a third node N3, and a plurality of light emitting elements LD electrically connected in a series/parallel connection to each other in the same direction between the first electrode PE1 and the second pixel electrode PE2.

Each of the light emitting elements LD included in the emission component EMU may include a first end electrically connected to the first driving power supply VDD (or the second node N2) through the first electrode PE1, and a second end electrically connected to the second driving power supply VSS (or the third node N3) through the second electrode PE2. The first driving power supply VDD and the second driving power supply VSS may have different potentials. For example, the first driving power supply VDD may be set as a high-potential power supply, and the second driving power supply VSS may be set as a low-potential power supply. Here, a difference in potential between the first and second driving power supplies VDD and VSS may be set to a value equal to or greater than a threshold voltage of the light emitting elements LD during an emission period of each pixel PXL.

As described above, the light emitting elements LD that are electrically connected in parallel to each other in the same direction (e.g., in a forward direction) between the first electrode PE1 and the second electrode PE2 to which the voltages of the different power supplies are supplied may form respective valid light sources.

The light emitting elements LD of the emission component EMU may emit light having a luminance corresponding to driving current supplied thereto through the pixel circuit PXC. For example, during each frame period, driving current that corresponds to a gray scale value of a corresponding frame data of the pixel circuit PXC may be supplied to the light emitting component EMU. The driving current supplied to the emission component EMU may be divided into parts which flow into the respective light emitting elements LD. Hence, each of the light emitting elements LD may emit light having a luminance corresponding to current applied thereto, so that the emission component EMU may emit light having a luminance corresponding to the driving current.

Although there has been described the embodiment in which the opposite ends of the light emitting elements LD are electrically connected in the same direction between the first and second driving power supplies VDD and VSS, embodiments of the present disclosure are not limited thereto. In one or more embodiments, the emission component EMU may further include at least one invalid light source, e.g., a reverse light emitting element LDr, as well as including the light emitting elements LD that form the respective valid light sources. The reverse light emitting element LDr, along with the light emitting elements LD that form the valid light sources, may be electrically connected in parallel to each other between the first and second electrodes PE1 and PE1. Here, the reverse light emitting element LDr may be electrically connected between the first and second electrodes PE1 and PE2 in a direction opposite to that of the light emitting elements LD. Even if a certain driving voltage (e.g., a forward driving voltage) is applied between the first and second electrodes PE1 and PE2, the reverse light emitting element LDr remains disabled. Hence, current substantially does not flow through the reverse light emitting element LDr.

The pixel circuit PXC may be electrically connected to a scan line Si and a data line Dj of the pixel PXL. The pixel circuit PXC may be electrically connected to a control line CLi and a sensing line SENj of the pixel PXL. For example, in case that the pixel PXL is disposed on an i-th row and a j-th column of the display area DA, the pixel circuit PXC of the pixel PXL may be electrically connected to an i-th scan line Si, a j-th data line Dj, an i-th control line CLi, and a j-th sensing line SENj of the display area DA.

The pixel circuit PXC may include first to third transistors T1, T2, and T3, and a storage capacitor Cst.

The first transistor T1 may be a driving transistor configured to control driving current to be applied to the emission component EMU and may be connected between the first driving power supply VDD and the emission component EMU. In detail, a first terminal of the first transistor T1 may be electrically connected to the first driving power supply VDD by only the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, the amount of driving current to be applied from the first driving power supply VDD to the emission component EMU through the second node N2. In one or more embodiments, the first terminal of the first transistor T1 may be a drain electrode, and the second terminal of the first transistor T1 may be a source electrode, and embodiments of the present disclosure are not limited thereto. In one or more embodiments, the first terminal may be a source electrode, and the second terminal may be a drain electrode.

The second transistor T2 may be a switching transistor that selects a pixel PXL in response to a scan signal and activates the pixel PXL, and may be connected between the data line Dj and the first node N1. A first terminal of the second transistor T2 may be connected to the data line Dj. A second terminal of the second transistor T2 may be electrically connected to the first node N1. A gate electrode of the second transistor T2 may be electrically connected to the scan line Si. The first terminal and the second terminal of the second transistor T2 are different terminals, and, for example, if the first terminal is a drain electrode, and the second terminal may be a source electrode.

When a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are electrically connected to each other. The second transistor T2 may transmit a data signal to the gate electrode of the first transistor T1.

The third transistor T3 may obtain a sensing signal through the sensing line SENj by connecting the first transistor T1 to the sensing line SENj, and detect, using the sensing signal, characteristics of the pixel PXL such as a threshold voltage of the first transistor T1. Information about the characteristics of the pixel PXL may be used to convert image data such that a deviation in characteristic between pixels PXL can be compensated for. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi. Furthermore, the first terminal of the third transistor T3 may be electrically connected to an initialization power supply. The third transistor T3 may be an initialization transistor configured to initialize the second node N2, and may be turned on when a sensing control signal is supplied thereto from the control line CLi, so that the voltage of the initialization power supply can be transmitted to the second node N2. Hence, a second storage electrode UE of the storage capacitor Cst that is electrically connected to the second node N2 may be initialized.

The storage capacitor Cst may include a first storage electrode LE and the second storage electrode UE. The first storage electrode LE may be electrically connected to the first node N1. The second storage electrode UE may be electrically connected to the second node N2. The storage capacitor Cst may be charged with a data voltage corresponding to a data signal to be supplied to the first node N1 during one frame period. Hence, the storage capacitor Cst may store a voltage (or a charge) corresponding to a difference between a voltage of the gate electrode of the first transistor T1 and a voltage of the second node N2.

The emission component EMU may include at least one series set (or stage) including a plurality of light emitting elements LD that are electrically connected in parallel to each other. In one or more embodiments, as illustrated in FIG. 5, the emission component EMU may have a series/parallel combination structure. For example, the emission component EMU may include a first series set SET1 and a second series set SET2 electrically connected to each other.

The emission component EMU may include the first series set SET1 and the series set SET2 that are successively and electrically connected between the first driving power supply VDD and the second driving power supply VSS. Each of the first and second series sets SET1 and SET2 may include two electrodes PE1 and CTE1, CTE2 and PE2 that form an electrode pair of the corresponding series set, and a plurality of light emitting elements LD electrically connected in parallel to each other in the same direction between the two electrodes PE1 and CTE1, CTE2 and PE2.

The first series set SET1 (or the first stage) may include a first electrode PE1, a first intermediate electrode CTE1, and at least one first light emitting element LD1 electrically connected between the first electrode PE1 and the first intermediate electrode CTE1. Furthermore, the first series set SET1 may include a reverse light emitting element LDr electrically connected between the first electrode PE1 and the first intermediate electrode CTE1 in a direction opposite to that of the first light emitting element LD1.

The second series set SET2 (or the second stage) may include a second intermediate electrode CTE2, a second electrode PE2, and at least one second light emitting element LD2 electrically connected between the second intermediate electrode CTE2 and the second electrode PE2. Furthermore, the second series set SET2 may include a reverse light emitting element LDr electrically connected between the second intermediate electrode CTE2 and the second electrode PE2 in a direction opposite to that of the second light emitting element LD2.

The first intermediate electrode CTE1 and the second intermediate electrode CTE2 may be electrically and/or physically connected with each other. The first intermediate electrode CTE1 and the second intermediate electrode CTE2 may form an intermediate electrode CTE that electrically connects the first series set SET1 and the second series set SET2 that are successively provided.

In the foregoing embodiment, the first electrode PE1 of the first series set SET1 may be an anode of each pixel PXL, and the second electrode PE2 of the second series set SET2 may be a cathode of the corresponding pixel PXL. The first electrode PE1 may be electrically connected with the pixel circuit PXC through the second node N2. The second electrode PE2 may be electrically connected to the second power line PL2 through the third node N3. The second node N2 may be a first point at which the pixel circuit PXC and the emission component EMU are electrically connected to each other. In one or more embodiments, the third node N3 may be a second point at which the pixel circuit PXC and the emission component EMU are electrically connected to each other.

As described above, the emission component EMU of the pixel PXL including the series sets SET1 and SET2 (or the light emitting elements LD) electrically connected to each other in the series/parallel combination structure may easily adjust driving current/voltage conditions in response to specifications of a product to which the emission component EMU is to be applied.

For example, the emission component EMU of the pixel PXL including the series sets SET1 and SET2 (or the light emitting elements LD) electrically connected to each other in the series/parallel combination structure may reduce driving current, compared to that of an emission component having a structure such that the light emitting elements LD are electrically connected only in parallel to each other. Furthermore, the emission component EMU of the pixel PXL including the series sets SET1 and SET2 electrically connected to each other in the series/parallel combination structure may reduce driving current to be applied to the opposite ends of the emission component EMU, compared to that of an emission component having a structure such that all of the light emitting elements LD, the number of which is the same as that of the emission component EMU, are electrically connected in series to each other. In addition, the emission component EMU of the pixel PXL including the series sets SET1 and SET2 (or the light emitting elements LD) electrically connected to each other in the series/parallel combination structure may increase the number of light emitting elements LD included between the electrodes PE1, CTE1, CTE2, and PE2, compared to that of an emission component having a structure such that all of the series sets (or stages) are electrically connected in series to each other. In this case, the light output efficiency of the light emitting elements LD may be enhanced. Even if a defect is caused in a specific series set (or stage), the ratio of light emitting elements LD that cannot emit light due to the defect may be reduced, so that a reduction in the light output efficiency of the light emitting elements LD can be mitigated.

FIG. 6 is a plan view schematically illustrating the display element layer DPL of the pixel PXL illustrated in FIG. 3.

In FIG. 6, for convenience of description, illustration of the transistors electrically connected to the light emitting elements LD and the signal lines electrically connected to the transistors is omitted.

In FIG. 6, for convenience of description, a horizontal direction in a plan view is indicated as a first direction DR1, and a vertical direction in a plan view is indicated as a second direction DR2.

Referring to FIGS. 1 to 6, the display element layer DPL of the pixel PXL may include light emitting elements LD that are electrically connected to a corresponding pixel circuit and are configured to emit light, and electrodes (or electrode patterns) that are electrically connected to the light emitting elements LD. For example, the emission component EMU of each pixel PXL may be disposed in the display element layer DPL.

The pixel PXL may include an emission area EMA, and a non-emission area NEA which encloses at least one side of the emission area EMA.

The display element layer DPL may include the first bank BNK1 disposed or located in the non-emission area NEA.

The first bank BNK1 may be a structure that defines (or partition) an emission area of each of adjacent pixels PXL, and may be a pixel defining layer. The first bank BNK1 may be a pixel defining layer or a dam structure formed to define a supply position of light emitting elements LD during a process of supplying (or inputting) the light emitting elements LD to each pixel PXL. Because the emission area EMA of each pixel PXL is partitioned (or defined) by the first bank BNK1, a mixed solution (e.g., ink) including a target amount and/or type of light emitting elements LD may be supplied (or input) to the emission area EMA.

In one or more embodiments, the first bank BNK1 may include at least one light shielding material and/or reflective material (or scattering material), thus preventing a light leakage defect in which light (or rays) leaks between adjacent pixels PXL. In one or more embodiments, the first bank BNK1 may include transparent material (or substance). The transparent material may include, for example, polyamides resin, polyimides resin, and the like, but embodiments of the present disclosure are not limited thereto. In one or more embodiments, in order to enhance the efficiency of light emitted from each pixel PXL, a separate reflective material layer may be provided and/or formed on the first bank BNK1.

The first bank BNK1 may include at least one opening OP that exposes some components of the display element layer DPL. In one or more embodiments, the emission area EMA of each pixel PXL and the opening OP of the first bank BNK1 may correspond to each other.

An electrode separation area OPA may be disposed in the non-emission area NEA of each pixel PXL. The electrode separation area OPA may be an area in which a first alignment electrode ALE1 in each pixel PXL is separated from a first alignment electrode ALE1 provided in a pixel PXL disposed adjacent thereto in the second direction DR2

The display element layer DPL may include an electrode PE (or a pixel electrode) provided or located in the emission area EMA, light emitting elements LD electrically connected to the electrode PE, and alignment electrodes ALE provided at a position corresponding to the pixel electrode PE. For example, a first electrode PE1 (or a first pixel electrode), a second electrode PE2 (or a second pixel electrode), the light emitting elements LD, and first and second alignment electrodes ALE1 and ALE2 may be disposed or located in the emission area EMA. Furthermore, an intermediate electrode CTE may be disposed or located in the emission area EMA. The pixel electrodes PE and/or the alignment electrodes ALE each may be changed in number, shape, size, arrangement structure, etc. in various ways depending on the structure of each pixel PXL.

Based on one surface of the substrate SUB on which each pixel PXL is disposed, the alignment electrodes ALE, the light emitting elements LD, and the electrodes PE may be provided in the order listed, but embodiments of the present disclosure are not limited thereto. In one or more embodiments, positions and a formation sequence of the electrode patterns included in the display element layer DPL may be changed in various ways.

The alignment electrodes ALE may include a second alignment electrode ALE2, a first alignment electrode ALE1, and another second alignment electrode ALE2 which are spaced apart from each other in the first direction DR1.

At least one of the second alignment electrode ALE2, the first alignment electrode ALE1, and the another second alignment electrode ALE2 may be separated from other electrodes (e.g., an alignment electrode ALE provided in an adjacent pixel adjacent to each pixel PXL in the second direction DR2) after the light emitting elements LD have been supplied to and aligned in the emission area EMA during a process of fabricating the display device DD. For example, the first alignment element ALE1 may be separated from a first alignment electrode ALE1 provided in an adjacent pixel adjacent to the corresponding pixel PXL after the light emitting elements LD have been supplied to and aligned in the emission area EMA during the process of fabricating the display device DD.

In detail, the first alignment electrodes ALE1 provided or located in the display area DA may be formed to be connected to each other during the process of fabricating the display device DD (or the pixel PXL). For example, the first alignment electrodes ALE1 may be integrally connected to a floating pattern FPT, thus forming the first alignment line. The floating pattern FPT may be electrically connected to a component of the pixel circuit layer PCL, for example, to the first power line (refer to "PL1" of FIG. 5), through a fourth contactor CNT4 and a fourth contact hole CH4. Hence, during a process of aligning the light emitting elements LD, a first alignment signal may be supplied to the first alignment line through the first power line PL1. After the process of aligning the light emitting elements LD has been completed, a portion of the first alignment line both around the fourth contactor CNT4 disposed in the non-emission area NEA and around the fourth contact hole CH4 overlapping the fourth contactor CNT4 may be removed (or the first alignment line may be cut off), whereby the electrical connection between the first alignment electrodes ALE1 and the first power line PL1 may be interrupted. For example, the first alignment line may be cut off in the electrode separation areas OPA (or disconnection areas) disposed around the floating pattern FPT (e.g., upper and lower end areas), so that the first alignment line may be divided into first alignment electrodes ALE1 and floating patterns FPT. Furthermore, the first alignment line may be cut off in the electrode separation area OPA between adjacent pixel columns, so that the first alignment electrodes ALE1 of adjacent pixels PXL can be separated from each other. Therefore, the first alignment electrodes ALE1 of the pixels PXL disposed on the same pixel column may be electrically separated from each other, whereby the pixels PXL may be individually driven. In one or more embodiments, the fourth contactor CNT4 and the fourth contact hole CH4 that overlap each other may be formed by removing portions of two insulating layers disposed between each floating pattern FPT and the first power line PL1.

In a plan view, the second alignment electrode ALE2, the first alignment electrode ALE1, and the another second alignment electrode ALE2 may be arranged along the first direction DR1 in the emission area EMA. The second alignment electrode ALE2 may be disposed adjacent to one side (e.g., a left side) of the first alignment electrode ALE1, and the another second alignment electrode ALE2 may be disposed adjacent to another side (e.g., a right side) of the first alignment electrode ALE1. The second alignment electrode ALE2, the first alignment electrode ALE1, and the another second alignment electrode ALE2 may be spaced from each other and extend in the second direction DR2.

The another second alignment electrode ALE2 may be electrically connected to a component of the pixel circuit PXC (or the pixel circuit layer PCL), e.g., to the second power line PL2, through a second contactor CNT2 and a second contact hole CH2 in the non-emission area NEA. The second contactor CNT2 and the second contact hole CH2 may be formed by removing portions of two insulating layers disposed between the another second alignment electrode ALE2 and the second power line PL2.

In the emission area EMA, at least one or more alignment electrodes ALE of the second alignment electrode ALE2, the first alignment electrode ALE1, and the another second alignment electrode ALE2 may be spaced from an alignment electrode ALE adjacent thereto in the first direction DR1. For example, in the emission area EMA, the second alignment electrode ALE2 may be spaced from the left side of the first alignment electrode ALE1 in the first direction DR1. The first alignment electrode ALE1 may be spaced from the another second alignment electrode ALE2 in the first direction DR1. The another second alignment electrode ALE2 may be spaced from the right side of the first alignment electrode ALE1 in the first direction DR1. A distance between the second alignment electrode ALE2 and the first alignment electrode ALE1 and a distance between the first alignment electrode ALE1 and the other alignment electrode ALE2 may be the same as each other, but embodiments of the present disclosure are not limited thereto.

In one or more embodiments, the second alignment electrodes ALE2 may be integrally formed with second alignment electrodes ALE2 disposed in an adjacent pixel PXL.

The second alignment electrode ALE2, the first alignment electrode ALE1, and the another second alignment electrode ALE2 each may be used as an alignment line provided for alignment of the light emitting elements LD and configured to receive a signal (e.g., an alignment signal) before the light emitting elements LD are aligned in the emission area EMA of each the pixels PXL.

The first alignment electrode ALE1 may receive a first alignment signal at the step of aligning the light emitting elements LD. The second alignment electrode ALE2 and the another second alignment electrode ALE2 each may receive a second alignment signal at the step of aligning the light emitting elements LD. The foregoing first and second alignment signals may be signals having a voltage difference and/or a phase difference, allowing the light emitting elements LD to be aligned between the alignment electrodes ALE. At least one of the first and second alignment signals may be an AC signal, but embodiments of the present disclosure are not limited thereto. In one or more embodiments, the first alignment signal supplied to the first alignment electrode ALE1 may be an AC signal. The second alignment signal supplied to each of the second alignment electrode ALE2 and the another second alignment electrode ALE2 may be a ground voltage. However, embodiments of the present disclosure are not limited thereto.

The second alignment electrode ALE2, the first alignment electrode ALE1, and the another second alignment electrode ALE2 each may be provided in the form of a bar having a constant width in at least the emission area EMA, but embodiments of the present disclosure are not limited thereto. The second alignment electrode ALE2, the first alignment electrode ALE1, and the another second alignment electrode ALE2 each may or may not have a curved part in the non-emission area NEA. The shape, size, and/or the like thereof in the other areas except the emission area EMA of embodiments may be changed in various ways without being particularly limited.

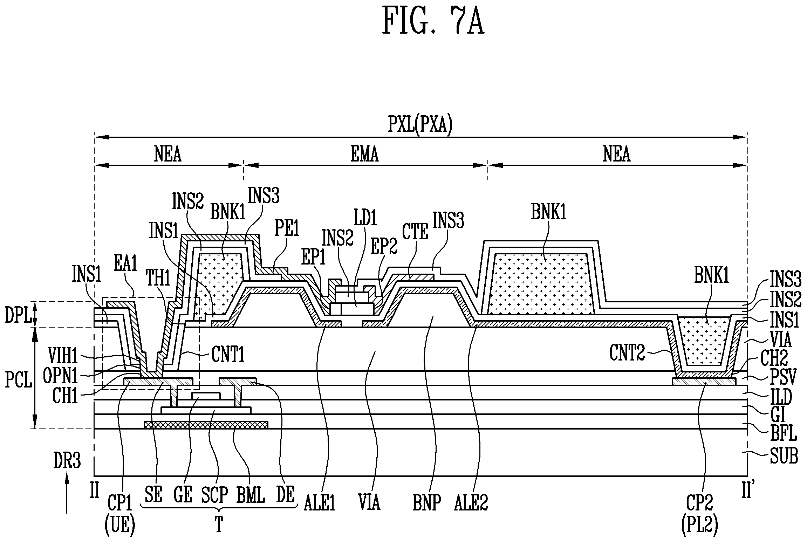

A bank pattern may be disposed under each of the alignment electrodes ALE so as to change a surface profile (or shape) of the alignment electrode ALE so that light emitted from the light emitting elements LD can be guided in an image display direction of the display device DD. The bank pattern will be described with reference to FIGS. 7A to 11B.

Although at least two to several tens of light emitting elements LD may be aligned and/or provided in the emission area EMA, the number of light emitting elements LD of embodiments is not limited thereto. In one or more embodiments, the number of light emitting elements LD aligned and/or provided in the emission area EMA may be changed in various ways.

The light emitting elements LD may be disposed or located between the second alignment electrode ALE2 and the first alignment electrode ALE1 and between the first alignment electrode ALE1 and the another second alignment electrode ALE2. Each of the light emitting elements LD may include a first end EP1 and a second end EP2 that are respectively disposed on opposite ends thereof in the longitudinal direction. In one or more embodiments, the second semiconductor layer (refer to "13" of FIG. 1) including a p-type semiconductor layer may be disposed or located on the first end EP1, and the first semiconductor layer (refer to "11" of FIG. 1) including an n-type semiconductor layer may be disposed or located on the second end EP2. The light emitting elements LD may be connected in parallel to each other between the second alignment electrode ALE2 and the first alignment electrode ALE1 and between the first alignment electrode ALE1 and the another second alignment electrode ALE2.

The light emitting elements LD may be disposed at positions spaced from each other and aligned in substantially parallel to each other. A distance by which the light emitting elements LD are spaced from each other is not particularly limited in embodiments. In one or more embodiments, a plurality of light emitting elements LD may be disposed adjacent to each other to form a group, and another plurality of light emitting elements LD may be spaced from each other at regular intervals to form a group. The light emitting elements LD may be aligned in one direction with an uneven density.

Each of the light emitting elements LD may emit any one light of color light and/or white light. The light emitting elements LD each may be aligned between the second alignment electrode ALE2 and the first alignment electrode ALE1 or between the first alignment electrode ALE1 and the another second alignment electrode ALE2 such that the longitudinal direction of the light emitting element LD is parallel to the first direction DR1. In one or more embodiments, at least some of the light emitting elements LD may be aligned between the second alignment electrode ALE2 and the first alignment electrode ALE1 and between the first alignment electrode ALE1 and the another second alignment electrode ALE2 such that the at least some of the light emitting elements LD are not completely parallel to the first direction DR1. The light emitting elements LD may be provided in a sprayed (or diffused) form in a solution (e.g., ink) and then input (or supplied) to the emission area EMA.

The light emitting elements LD may be inputted (or supplied) to the emission area EMA by an inkjet printing scheme, a slit coating scheme, or other various schemes. For example, the light emitting elements LD may be mixed with a volatile solvent and then inputted (or supplied) to the emission area EMA by an inkjet printing scheme or a slit coating scheme. Here, if the second alignment electrode ALE2, the first alignment electrode ALE1, and the another second alignment electrode ALE2 are respectively supplied with corresponding alignment signals, electric fields may be respectively formed between the second alignment electrode ALE2 and the first alignment electrode ALE1 and between the first alignment electrode ALE1 and the other alignment electrode ALE2. Hence, the light emitting elements LD may be aligned between the second alignment electrode ALE2 and the first alignment electrode ALE1 and between the first alignment electrode ALE1 and the another second alignment electrode ALE2. After the light emitting elements LD have been aligned, the solvent may be removed by a volatilization scheme or other schemes, so that the light emitting elements LD may be reliably aligned between the second alignment electrode ALE2 and the first alignment electrode ALE1 and between the first alignment electrode ALE1 and the another second alignment electrode ALE2.

In one or more embodiments, the light emitting elements LD may include a first light emitting element LD1 and a second light emitting element LD2.

The first light emitting element LD1 may be aligned between the right side of the first alignment electrode ALE1 and the another second alignment electrode ALE2 and electrically connected to the first electrode PE1 and the intermediate electrode CTE. The second light emitting element LD2 may be aligned between the left side of the first alignment electrode ALE1 and the second alignment electrode ALE2 and electrically connected to the intermediate electrode CTE and the second electrode PE2.

A plurality of first light emitting elements LD1 and a plurality of second light emitting elements LD2 may be provided. The first end EP1 of each of the first light emitting elements LD1 may be electrically connected to the first electrode PE1. The second end EP2 of each of the first light emitting elements LD1 may be electrically connected to the intermediate electrode CTE. The first end EP1 of each of the second light emitting elements LD2 may be electrically connected to the intermediate electrode CTE. The second end EP2 of each of the second light emitting elements LD2 may be electrically connected to the second electrode PE2.

The first light emitting elements LD1 may be connected in parallel to each other between the first electrode PE1 and the intermediate electrode CTE. The second light emitting elements LD2 may be electrically connected in parallel to each other between the intermediate electrode CTE and the second electrode PE2.

In one or more embodiments, the first light emitting elements LD1 and the second light emitting elements LD2 each may be formed of a light emitting diode which is made of material having an inorganic crystal structure and has a subminiature size, e.g., ranging from the nano scale (or the nanometer scale) to the micro scale (or the micrometer scale). For example, the first light emitting elements LD1 and the second light emitting elements LD2 each may be the light emitting element LD described with reference to FIGS. 1 and 2.

The electrodes PE and the intermediate electrode CTE may be provided or located in at least the emission area EMA of the pixel PXL, and each may be provided at a position corresponding to at least one alignment electrode ALE and at least one light emitting element LD. For example, each electrode PE and each intermediate electrode CTE may be formed on the corresponding alignment electrodes ALE and the corresponding light emitting elements LD to overlap the alignment electrodes ALE and the light emitting elements LD, and thus electrically connected to at least the light emitting elements LD.

The first electrode PE1 (or the first pixel electrode) may be formed on the right side of the first alignment electrode ALE1 and the respective first ends EP1 of the first light emitting elements LD1, and thus electrically connected to the respective first ends EP1 of the first light emitting elements LD1. The first electrode PE1 may have a bar shape having a constant width in an extension direction thereof, e.g., the second direction DR2.

The second electrode PE2 (or the second pixel electrode) may be formed on the second alignment electrode ALE2 and the respective second ends EP of the second light emitting elements LD2, and thus electrically connected to the respective second ends EP2 of the second light emitting elements LD2. The second electrode PE2 may have a bar shape having a constant width in an extension direction thereof, e.g., the second direction DR2.

The intermediate electrode CTE may be formed on the left side of the first alignment electrode ALE1 and the respective first ends EP1 of the second light emitting elements LD2, and thus electrically connected to the respective first end EP1 of the second light emitting elements LD2. Furthermore, the intermediate electrode CTE may be formed on the another second alignment electrode ALE2 and the respective second ends EP2 of the first light emitting elements LD1, and thus electrically connected to the respective second ends EP2 of the first light emitting elements LD1. The intermediate electrode CTE may be bent at least one or more times to enclose at least one side of the first electrode PE1.

The first light emitting element LD1 may be electrically connected in series to the second light emitting element LD2 by the intermediate electrode CTE. The first electrode PE1 and the intermediate electrode CTE, along with the first light emitting elements LD1 electrically connected in parallel therebetween, may form a first series set SET1 of the emission component EMU of the display element layer DPL. The intermediate electrode CTE and the second electrode PE2, along with the second light emitting elements LD2 electrically connected in parallel therebetween, may form a second series set SET2 of the emission component EMU. The first electrode PE1 may be an anode of the emission component EMU. The second electrode PE2 may be a cathode of the emission component EMU.

In one or more embodiments, the first electrode PE1 may be electrically connected to a component of the pixel circuit PXC (or the pixel circuit layer PCL) through a first via hole VIH1, a first opening OPN1, a first through hole TH1, a first contactor CNT1, and a first contact hole CH1 that overlap each other on the second node N2. For example, the first electrode PE1 may be physically and/or electrically connected to the second storage electrode UE of the storage capacitor Cst of the pixel circuit PXC (or the pixel circuit layer PCL) through the first via hole VIH1, the first opening OPN1, the first through hole TH1, the first contactor CNT1, and the first contact hole CH1 on the second node N2. The first via hole VIH1, the first opening OPN1, the first through hole TH1, the first contactor CNT1, and the first contact hole CH1 may be formed by removing portions of a plurality of insulating layers between the first electrode PE1 and the second storage electrode UE that are located on the second node N2.

The second electrode PE2 may be electrically connected to a component of the pixel circuit PXC (or the pixel circuit layer PCL) through a second via hole VIH2, a second opening OPN2, a second through hole TH2, a third contactor CNT3, and a third contact hole CH3 that are located in the non-emission area NEA and overlap each other on the third node N3. For example, the second electrode PE2 may be physically and/or electrically connected to the second power line PL2 of the pixel circuit PXC (or the pixel circuit layer PCL) through the second via hole VIH2, the second opening OPN2, the second through hole TH2, the third contactor CNT3, and the third contact hole CH3. The second via hole VIH2, the second opening OPN2, the second through hole TH2, the third contactor CNT3, and the third contact hole CH3 may be formed by removing portions of a plurality of insulating layers between the second electrode PE2 and the second power line PL2 that are located on the third node N3.

Detailed descriptions of the first to fourth contact holes CH1 to CH4, the first to fourth contactor CNT1 to CNT4, the first and second through hole TH1 and TH2, the first and second openings OPN1 and OPN2, and the first and second via holes VIH1 and VIH2 will be made below with reference to FIGS. 7A to 11B.

The first light emitting element LD1 and the second light emitting element LD2 may be electrically connected in series to each other through the intermediate electrode CTE between the first electrode PE1 and the second electrode PE2. In this way, the light emitting elements LD aligned in the emission area EMA may be electrically connected in a series/parallel combination structure to form the emission component EMU of the pixel PXL.

Because a component (e.g., the second storage electrode UE) of the pixel circuit PXC is brought into direct contact with and electrically connected to the first electrode PE1 of the display element layer DPL through the first via hole VIH1, the first opening OPN1, the first through hole TH1, the first contactor CNT1, and the first contact hole CH1 on the second node N2, and because a component (e.g., the second power line PL2) of the pixel circuit PXC is brought into direct contact with and electrically connected to the second electrode PE2 of the display element layer DPL through the second via hole VIH2, the second opening OPN2, the second through hole TH2, the third contactor CNT3, and the third contact hole CH3 on the third node N3, driving current may flow from the first electrode PE1 to the second electrode PE2 via the first light emitting element LD1, the intermediate electrode CTE, and the third light emitting element LD2.

In one or more embodiments, the first electrode PE1 and the second electrode PE2 may be used as driving electrodes configured to drive the light emitting elements LD.

In accordance with the foregoing embodiment, some components (e.g., conductive patterns made of copper or the like) of the pixel circuit PXC can be prevented from making direct contact with the alignment electrodes ALE, so that a defect (e.g., corrosion) which may occur between some components and the alignment electrode ALE during a fabrication process due to respective material characteristics of some components and the alignment electrode ALE may be prevented or reduced.

Furthermore, in accordance with the foregoing embodiment, because the first electrode PE1 is brought into direct contact with and connected to some components of the pixel circuits PXC, contact (e.g., physical connection and electrical connection) between the first electrode PE1 and the alignment electrodes ALE may be prevented or reduced. Therefore, the first electrode PE1 can be prevented from making direct contact with the alignment electrodes ALE that has a relatively large resistance due to material characteristics and/or oxidation or the like which occurs during the fabrication process. Hence, the contact resistance of the first electrode PE1 can be prevented from increasing.

Hereinafter, the stacked structure of the pixel PXL in accordance with the foregoing embodiment will be mainly described with reference to FIGS. 7A to 11B.

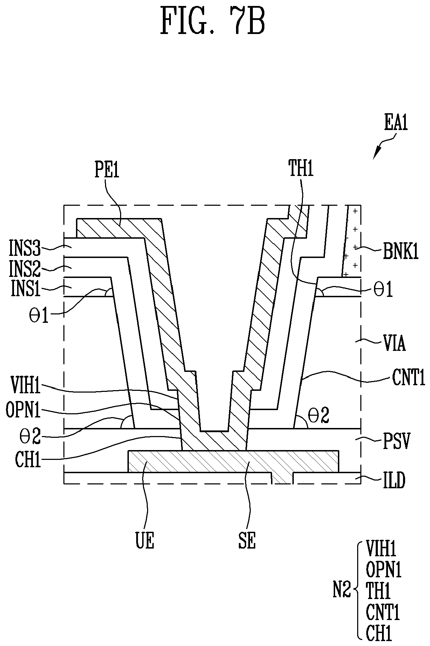

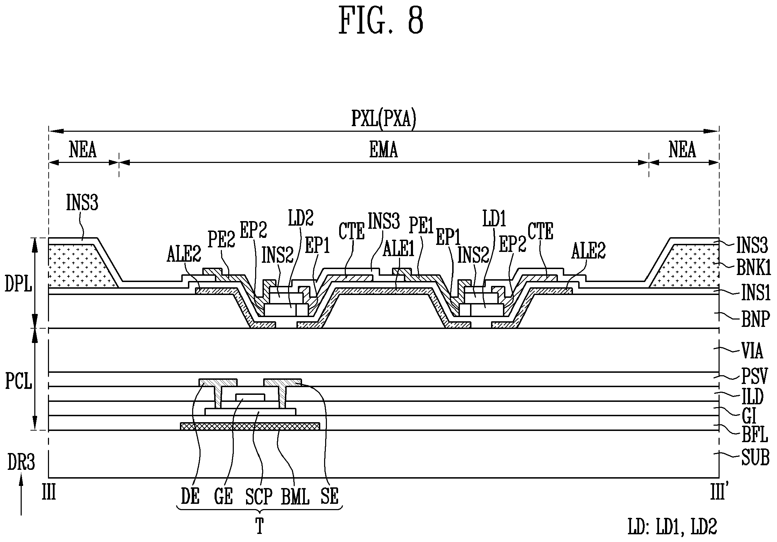

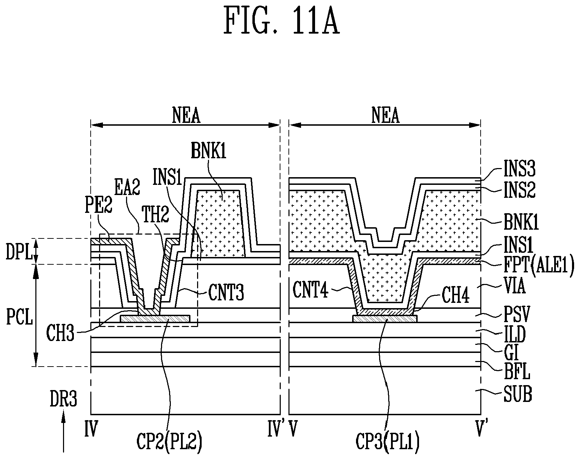

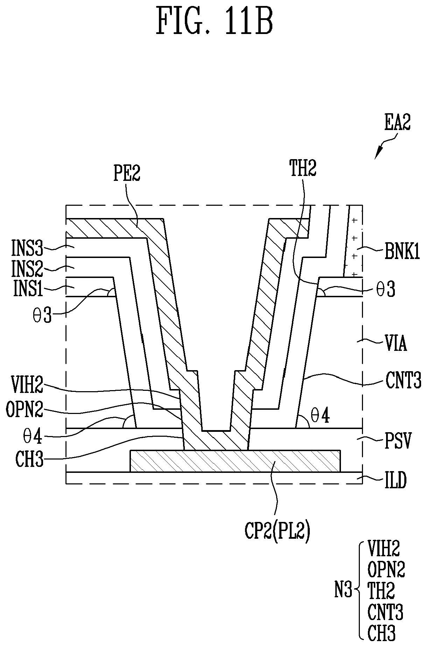

FIG. 7A is a schematic cross-sectional view taken along the line II-II' of FIG. 6. FIG. 7B is a schematic enlarged view of portion EA1 of FIG. 7A. FIGS. 8 to 10 are schematic cross-sectional views taken along the line III-III' of FIG. 6. FIG. 11A shows schematic cross-sectional views taken along the line IV-IV' and the line V-V' of FIG. 6. FIG. 11B is a schematic enlarged view of portion EA2 of FIG. 11A.

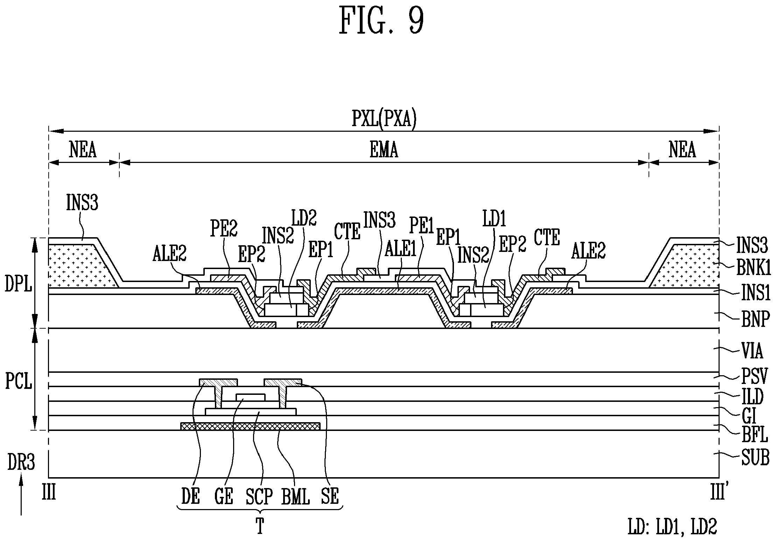

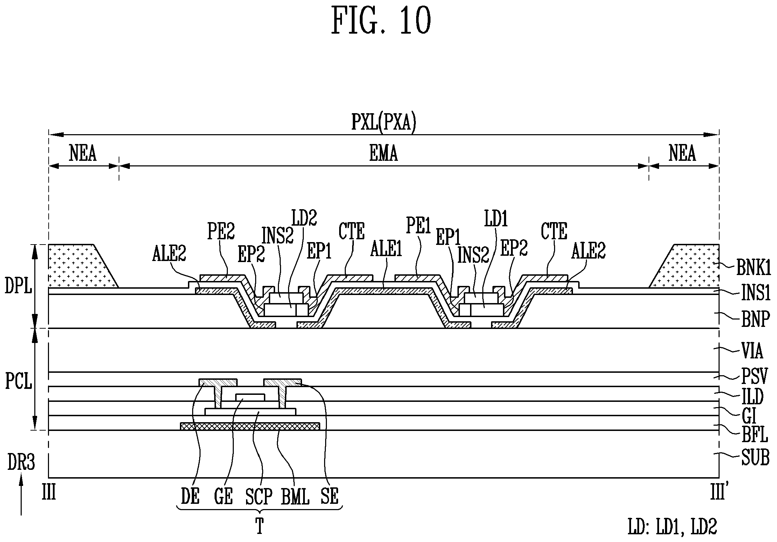

Embodiments of FIGS. 9 and 10 refer to modifications of the embodiment of FIG. 8 pertaining both to the step of forming the electrode PE and the intermediate electrode CTE and to whether a third insulating layer INS3 is present. For example, FIG. 9 illustrates an embodiment in which the first and second electrodes PE1 and PE2 are formed before the intermediate electrode CTE and the third insulating layer INS3 are formed. FIG. 10 illustrates an embodiment in which the first and second electrodes PE1 and PE2 and the intermediate electrode CTE are formed through the same process.

In FIGS. 7A to 11B, a vertical direction in a cross-sectional view is illustrated as a third direction DR3.

The following description related to the embodiments of FIGS. 7A to 11B will be focused on differences from the above-mentioned embodiments so as to avoid redundant description.

Referring to FIGS. 1 to 11B, the pixel PXL may include a substrate SUB, a pixel circuit layer PCL, and a display element layer DPL.

The pixel circuit PXC including circuit elements may be disposed in the pixel circuit layer PCL. The emission component EMU including the light emitting element LD which is electrically connected to the pixel circuit PXC may be disposed in the display element layer DPL.

The pixel circuit layer PCL and the display element layer DPL may be disposed or located on one surface of the substrate SUB and overlap each other. For example, the pixel area PXA of the substrate SUB may include the pixel circuit layer PCL disposed or located on one surface of the substrate SUB, and the display element layer DPL disposed or located on the pixel circuit layer PCL. However, relative positions of the pixel circuit layer PCL and the display element layer DPL on the substrate SUB may be changed depending on embodiments. In case that the pixel circuit layer PCL and the display element layer DPL are separated from each other as separate layers and overlap each other, layout space sufficient to form each of the pixel circuit PXC and the emission component EMU may be secured. In one or more embodiments, the pixel circuit layer PCL and the display element layer DPL may be disposed or located on the same plane without overlapping each other.

The pixel circuit layer PCL may include at least one or more insulating layers disposed on the substrate SUB. For example, the pixel circuit layer PCL may include a buffer layer BFL, a gate insulating layer GI, an interlayer insulating layer ILD, a passivation layer PSV, and a via layer VIA that are successively stacked on one surface of the substrate SUB in the third direction DR3.

The buffer layer BFL may be disposed on the overall surface of the substrate SUB. The buffer layer BFL may prevent impurities from diffusing into the transistors T1, T2, and T3 included in the pixel circuit PXC. The buffer layer BFL may be an inorganic insulating layer including inorganic material. The buffer layer BFL may include at least one of silicon nitride (SiNₓ), silicon oxide (SiOₓ), silicon oxynitride (SiOₓN_{y}), and metal oxide such as aluminum oxide (AlOₓ). The buffer layer BFL may be provided in the form of a single layer structure, or provided in the form of a multilayer structure having at least two or more layers. In case that the buffer layer BFL is provided in the form of a multilayer structure, the respective layers may be formed of the same material or different materials. The buffer layer BFL may be omitted depending on the material of the substrate SUB or processing conditions.

The gate insulating layer GI may be disposed on the overall surface of the buffer layer BFL. The gate insulating layer GI may include the same material as that of the buffer layer BFL, or include suitable material from among the materials exemplified as the constituent materials of the buffer layer BFL. The gate insulating layer GI may be an inorganic insulating layer including inorganic material.

The interlayer insulating layer ILD may be provided and/or formed on the overall surface of the gate insulating layer GI. The interlayer insulating layer ILD may include the same material as that of the gate insulating layer GI, or may include one or more materials selected from among materials exemplified as the constituent material of the gate insulating layer GI.

The passivation layer PSV may be provided and/or formed on the overall surface of the interlayer insulating layer ILD. The passivation layer PSV may be an inorganic insulating layer including inorganic material or an organic insulating layer including organic material. The inorganic insulating layer may include, for example, at least one of silicon oxide (SiOₓ), silicon nitride (SiNₓ), silicon oxynitride (SiOₓN_{y}), and metal oxide such as aluminum oxide (AlOₓ). The organic insulating layer may include, for example, at least one of polyacrylates resin, epoxy resin, phenolic resin, polyamides resin, polyimides rein, unsaturated polyesters resin, poly-phenylen ethers resin, poly-phenylene sulfides resin, and benzocyclobutene resin.

The passivation layer PSV may be partially open to allow some components of the pixel circuit PXC to be exposed. For example, the passivation layer PSV may be partially open to include the first contact hole CH1 through which one area of a first conductive pattern CP1 is exposed, the second contact hole CH2 through which one area of a second conductive pattern CP2 is exposed, the third contact hole CH3 through which another area of the second conductive pattern CP2 is exposed, and the fourth contact hole CH4 through which one area of a third conductive pattern CP3 is exposed (e.g., see FIGS. 7A and 11A).

The via layer VIA may be provided and/or formed on the overall surface of the passivation layer PSV. The via layer VIA may be formed of a single layer including an organic layer, or multiple layers having double or more layers. In one or more embodiments, the via layer VIA may be provided in a shape including an inorganic layer and an organic layer disposed on the inorganic layer. In case that the via layer VIA is formed of multiple layers having double or more layers, the organic layer included in the via layer VIA may be located on the uppermost layer of the via layer VIA. The via layer VIA may include at least one of polyacrylates resin, epoxy resin, phenolic resin, polyamides resin, polyimides rein, unsaturated polyesters resin, poly-phenylen ethers resin, poly-phenylene sulfides resin, and benzocyclobutene resin.

The via layer VIA may be partially open to include the first, second, third, and fourth contactors CNT1, CNT2, CNT3, and CNT4 corresponding to the first, second, third, and fourth contact holes CH1, CH2, CH3, and CH4 of the passivation layer PSV (e.g., see FIGS. 7A and 11A). For example, the first contactor CNT1 of the via layer VIA may correspond to and overlap the first contact hole CH1 of the passivation layer PSV. The second contactor CNT2 of the via layer VIA may correspond to and overlap the second contact hole CH2 of the passivation layer PSV. The third contactor CNT3 of the via layer VIA may correspond to and overlap the third contact hole CH3 of the passivation layer PSV. The fourth contactor CNT4 of the via layer VIA may correspond to and overlap the fourth contact hole CH4 of the passivation layer PSV.

In one or more embodiments, the via layer VIA may be used as a planarization layer formed to mitigate a step difference that occurs due to components of the pixel circuit PXC that are disposed under the via layer VIA in the pixel circuit layer PCL.

The pixel circuit layer PCL may include at least one or more conductive layers disposed between the above-mentioned insulating layers. For example, the pixel circuit layer PCL may include a first conductive layer disposed between the substrate SUB and the buffer layer BFL, a second conductive layer disposed on the gate insulating layer GI, and a third conductive layer disposed on the interlayer insulating layer ILD.

The first conductive layer may have a single-layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double-layer or multi-layer structure formed of molybdenum (Mo), titanium (Ti), copper (Cu), aluminum (Al), or silver (Ag), which is low resistance material, to reduce line resistance. Each of the second and third conductive layers may include the same material as that of the first conductive layer, or include one or more suitable materials from among the materials provided as examples of the constituent material of the first conductive layer, but embodiments of the present disclosure are not limited thereto.

In one or more embodiments, the substrate SUB may include transparent insulating material to allow light transmission. The substrate SUB may be a rigid substrate or a flexible substrate.

For example, the rigid substrate SUB may be one of a glass substrate, a quartz substrate, a glass ceramic substrate, and a crystalline glass substrate.

The flexible substrate SUB may be either a film substrate or a plastic substrate that includes polymer organic material. For example, the flexible substrate SUB may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

The pixel circuit PXC may include at least one or more transistors T. The transistor T may be a driving transistor configured to control driving current of the light emitting element LD, and have the same configuration as that of the first transistor T1 described with reference to FIG. 5.

The transistor T may include a semiconductor pattern SCP, a gate electrode GE that overlaps a portion of the semiconductor pattern SCP in the third direction DR3, and source and drain electrodes SE and DE that are connected to the semiconductor pattern SCP.

The gate electrode GE may be provided and/or formed on the gate insulating layer GI. For example, the gate electrode GE may be a second conductive layer disposed between the gate insulating layer GI and the interlayer insulating layer ILD. The gate electrode GE may overlap a portion of the semiconductor pattern SCP in the third direction DR3. For example, the gate electrode GE may overlap an active pattern of the semiconductor pattern SCP.

The semiconductor pattern SCP may be provided and/or formed on the buffer layer BFL. For example, the semiconductor pattern SCP may be disposed between the buffer layer BFL and the gate insulating layer GI. The semiconductor pattern SCP may be a semiconductor layer formed of polysilicon, amorphous silicon, an oxide semiconductor, and the like. The semiconductor pattern SCP may include an active pattern, a first contact area, and a second contact area. The active pattern, the first contact area, and the second contact area each may be formed of a semiconductor layer that is doped with no impurity or doped with an impurity. For example, the first contact area and the second contact area each may be formed of a semiconductor layer that is doped with an impurity, and the active pattern may be formed of an undoped semiconductor layer. For example, an n-type impurity may be used as the impurity, but embodiments of the present disclosure are not limited thereto.

The active pattern of the semiconductor pattern SCP may be an area that overlaps the gate electrode GE of the transistor T, and be a channel area. The first contact area of the semiconductor pattern SCP may contact one end of the active pattern. Furthermore, the first contact area may be connected to the source electrode SE. The second contact area of the semiconductor pattern SCP may contact a remaining end of the active pattern. Furthermore, the second contact area may be connected to the drain electrode DE.

The source electrode SE may be a third conductive layer provided and/or formed on the interlayer insulating layer ILD. The source electrode SE may contact the first contact area of the semiconductor pattern SCP through a contact hole that passes through the gate insulating layer GI and the interlayer insulating layer ILD.

The drain electrode DE may be a third conductive layer provided and/or formed on the interlayer insulating layer ILD. The drain electrode DE may be disposed on the interlayer insulating layer ILD at a position spaced from the source electrode SE. The drain electrode DE may contact the second contact area of the semiconductor pattern SCP through a contact hole that passes through the gate insulating layer GI and the interlayer insulating layer ILD.

The bottom metal pattern BML may be disposed under the transistor T.

The bottom metal pattern BML may be the first conductive layer disposed between the substrate SUB and the buffer layer BFL. The bottom metal pattern BML may be electrically connected to the transistor T. In this case, a driving range of a certain voltage to be applied to the gate electrode GE of the transistor T may be increased. In one or more embodiments, the bottom metal pattern BML may be electrically connected to the semiconductor pattern SCP of the transistor T and stabilize the channel area of the transistor T. Furthermore, because the bottom metal pattern BML is electrically connected to the transistor T, the bottom metal pattern BML may be prevented from floating.

Although in the foregoing embodiment there has been illustrated the case where the transistor T is a thin-film transistor having a top gate structure, embodiments of the present disclosure are not limited thereto. The structure of the transistor T may be changed in various ways.

The pixel circuit layer PCL may include first, second, and third conductive patterns CP1, CP2, and CP3 disposed on the interlayer insulating layer ILD. The first, second, and third conductive patterns CP1, CP2, and CP3 may be third conductive layers disposed on the interlayer insulating layer ILD at positions spaced from each other.

The first conductive pattern CP1 may be electrically connected to the source electrode SE of the transistor T. In one or more embodiments, the first conductive pattern CP1 and the source electrode SE may be integrally formed. The first conductive pattern CP1 may correspond to the second storage electrode UE of the storage capacitor Cst. The first conductive pattern CP1 may be brought into direct contact with and electrically connected to the first electrode PE1 of the display element layer DPL on the second node N2 through the first contact hole CH1 of the passivation layer PSV, the first contactor CNT1 of the via layer VIA, the first through hole TH1 of a first insulating layer INS1, the first opening OPN1 of a second insulating layer INS2, and the first via hole VIH1 of the third insulating layer INS3. In one or more embodiments, the second node N2 may be an area where the first contact hole CH1, the first contactor CNT1, the first through hole TH1, the first opening OPN1, and the first via hole VIH1 are located, and may be a connection point between the first conductive pattern CP1 (or the second storage electrode UE) and the first electrode PE1.

The second conductive pattern CP2 may be a second power line PL2 to which a voltage of the second driving power supply VSS is to be applied. The second conductive pattern CP2 may be brought into direct contact with and electrically connected to the second alignment electrode ALE2 of the display element layer DPL through the second contact hole CH2 of the passivation layer PSV and the second contactor CNT2 of the via layer VIA (e.g., see FIG. 7A). The second conductive pattern CP2 may be brought into direct contact with and electrically connected to the second electrode PE2 of the display element layer DPL on the third node N3 through the third contact hole CH3 of the passivation layer PSV, the third contactor CNT3 of the via layer VIA, the second through hole TH2 of the first insulating layer INS1, the second opening OPN2 of the second insulating layer INS2, and the second via hole VIH2 of the third insulating layer INS3 (e.g., see FIGS. 11A-11B). In one or more embodiments, the third node N3 may be an area where the third contact hole CH3, the third contactor CNT3, the second through hole TH2, the second opening OPN2, and the second via hole VIH2 are located, and may be a connection point between the second conductive pattern CP2 (or the second power line PL2) and the second electrode PE2.

The third conductive pattern CP3 may be a first power line PL1 to which a voltage of the first driving power supply VDD is to be applied. The third conductive pattern CP3 may be brought into direct contact with and electrically connected to the floating pattern FPT of the display element layer DPL through the fourth contact hole CH4 of the passivation layer PSV and the fourth contactor CNT4 of the via layer VIA (e.g., see FIG. 11A).

The display element layer DPL may be provided and/or formed on the via layer VIA.

The display element layer DPL of each pixel PXL may include the first and second alignment electrodes ALE1 and ALE2, at least one light emitting element LD, and the first and second electrodes PE1 and PE2 that are disposed or located in the emission area EMA. In one or more embodiments, the emission component EMU may include a plurality of light emitting elements LD.

Furthermore, the display element layer DPL may further include insulating patterns and/or insulating layers that are successively disposed on one surface of the pixel circuit layer PCL. For example, the display element layer DPL may further include bank patterns BNP, a first insulating layer INS1, a first bank BNK1, a second insulating layer INS2, and a third insulating layer INS3.

The bank patterns BNP each may be provided and/or formed on the via layer VIA of the pixel circuit layer PCL.

The bank pattern BNP (referred also to as "support component" or "wall pattern") may be provided and/or formed on the via layer VIA of the pixel circuit layer PCL. In one or more embodiments, the bank pattern BNP may be formed of a separate pattern that is individually disposed under each of the first and second alignment electrodes ALE1 and ALE2 such that the separate pattern overlaps a portion of a corresponding one of the first and second alignment electrodes ALE1 and ALE2.

In one or more embodiments, the bank pattern BNP may be formed of an integrated pattern that have an opening or a concave portion corresponding to areas between the first and second alignment electrodes ALE1 and ALE2 in the emission area EMA and is entirely integrally formed in the display area DA.

The bank pattern BNP may protrude upward in the third direction DR3 on one surface of the pixel circuit layer PCL. Hence, one area of each of the first and second alignment electrodes ALE1 and ALE2 disposed on the bank pattern BNP may protrude in the third direction DR3 (or the thickness direction of the substrate SUB).

The bank pattern BNP may be an inorganic insulating layer including inorganic material or an organic insulating layer including organic material. In one or more embodiments, the bank pattern BNP may include an organic layer having a single layer structure and/or an inorganic layer having a single layer structure, but embodiments of the present disclosure are not limited thereto. In one or more embodiments, the bank pattern BNP may be provided in the form of a multilayer structure formed by stacking at least one organic insulating layer and at least one inorganic insulating layer. However, the material of the bank pattern BNP is not limited to the foregoing embodiment. In one or more embodiments, the bank pattern BNP may include conductive material (or conductive substance). The shape of the bank pattern BNP may be changed in various ways within a range in which efficiency of light emitted from the light emitting element LD can be enhanced.

The bank pattern BNP may be used as a reflector. For example, the bank pattern BNP, along with the first and second alignment electrodes ALE1 and ALE2 disposed thereover, may be used as a reflector to guide light emitted from the light emitting element LD in a desired direction, so that the light output efficiency of the pixel PXL can be enhanced.

The first and second alignment electrodes ALE1 and ALE2 may be provided and/or formed on the bank pattern BNP.

The first and second alignment electrodes ALE1 and ALE2 may be provided and/or formed on the pixel circuit layer PCL (or the via layer VIA) and the bank pattern BNP.

The first alignment electrode ALE1 and the second alignment electrode ALE2 may be arranged in one direction, e.g., a horizontal direction, intersecting the third direction DR3, in a sectional view. The first alignment electrode ALE1 and the second alignment electrode ALE2 may be spaced from each other. The first alignment electrode ALE1 and the second alignment electrode ALE2 may be disposed on the same plane, and have the same thickness in the third direction DR3. The first alignment electrode ALE1 and the second alignment electrode ALE2 may be concurrently (e.g., simultaneously) formed through the same process.

The first alignment electrode ALE1 and the second alignment electrode ALE2 each may have a shape corresponding to a profile of the bank pattern BNP disposed thereunder.

The first alignment electrode ALE1 and the second alignment electrode ALE2 each may be formed of material having a certain (or uniform) reflectivity to allow light emitted from the light emitting elements LD to travel in an image display direction (e.g., the third direction DR3) of the display device DD. For example, the first alignment electrode ALE1 and the second alignment electrode ALE2 each may be formed of conductive material (or substance). The conductive material may include opaque metal that is suitable for reflecting, in the image display direction (or an upward direction of the display element layer DPL) of the display device DD, light emitted from the light emitting elements LD. For example, the opaque metal may include metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. In one or more embodiments, the first alignment electrode ALE1 and the second alignment electrode ALE2 each may include opaque metal such as aluminum (Al).

Although the first alignment electrode ALE1 and the second alignment electrode ALE2 each may be provided and/or formed in the form of a single layer structure, embodiments of the present disclosure are not limited thereto. In one or more embodiments, the first alignment electrode ALE1 and the second alignment electrode ALE2 each may be provided and/or formed to have a multilayer structure formed by stacking at least two materials from among metals, alloys, conductive oxide, and conductive polymers. The first alignment electrode AL1 and the second alignment electrode ALE2 each may be provided in the form of a multilayer structure including at least double layers to reduce or minimize a distortion due to a signal delay when signals are transmitted to the opposite ends EP1 and EP2 of the light emitting elements LD.

In case that the first alignment electrode ALE1 and the second alignment electrode ALE2 each are formed of conductive material having a reflectivity, light emitted from the opposite ends EP1 and EP2 of each of the light emitting elements LD may more reliably travel in the image display direction (e.g., the third direction DR3) of the display device DD. For example, if the first alignment electrode ALE1 and the second alignment electrode ALE2 have inclined surfaces or curved surfaces that corresponds to the shape of the bank pattern BNP and are disposed to oppose the opposite ends EP1 and EP2 of each of the light emitting elements LD, light emitted from the opposite ends EP1 and EP2 of each of the light emitting elements LD may be reflected by the first alignment electrode ALE1 and the second alignment ALE2 and more reliably travel in the image display direction (e.g., the third direction DR3) of the display device DD. Consequently, the efficiency of light emitted from the light emitting elements LD may be enhanced.

In one or more embodiments, at least one first alignment electrode ALE1 and at least one second alignment electrode ALE2 may be disposed in the emission area EMA. For example, one first alignment electrode ALE1 may be disposed in a central portion of the emission area EMA, and two second alignment electrodes ALE2 may be disposed on opposite sides of the first alignment electrode ALE1. The second alignment electrodes ALE2 may be integrally or non-integrally connected to each other and supplied with the same signal or power. The number, shape, size, position, and/or the like of each of the first and second alignment electrodes ALE1 and ALE2 disposed in the emission area EMA may be changed in various ways depending on embodiments.

The first insulating layer INS1 may be disposed on the first and second alignment electrodes ALE1 and ALE2.

The first insulating layer INS1 may be provided and/or formed on overall surfaces of the first and second alignment electrodes ALE1 and ALE2 and the bank pattern BNP. The first insulating layer INS1 may be partially open in the non-emission area NEA so that components disposed thereunder can be exposed. For example, the first insulating layer INS1 may be partially open to include the first through hole TH1 corresponding to the first contactor CNT1 of the via layer VIA so that one area of the first conductive pattern CP1 can be exposed, and may be partially open to include the second through hole TH2 corresponding to the third contactor CNT3 of the via layer VIA so that another area of the second conductive pattern CP2 can be exposed.

The first through hole TH1 of the first insulating layer INS1, the first contactor CNT1 of the via layer VIA, and the first contact hole CH1 of the passivation layer PSV may overlap each other in the non-emission area NEA.

In one or more embodiments, opposite side surfaces of the via layer VIA with the first contactor CTN1 formed therebetween may have an inclination angle θ2 ("gradient" or "inclination") substantially identical or similar to an inclination angle θ1 ("gradient" or "inclination") of opposite side surfaces of the first insulating layer INS1 with the first through hole TH1 formed therebetween. In this case, the opposite side surfaces of the first insulating layer INS1 (or an edge of the first through hole TH1 of the first insulating layer INS1) and the opposite side surfaces of the via layer VIA (or the contactor CNT1 of the via layer VIA) may correspond to (match with) each other. In other words, the opposite side surfaces of the first insulating layer INS1 (or the edge of the first through hole TH1) may be located on the same line as the opposite side surfaces of the via layer VIA (or the first contactor CNT1).

The second through hole TH2 of the first insulating layer INS1, the third contactor CNT3 of the via layer VIA, and the third contact hole CH3 of the passivation layer PSV may overlap each other in the non-emission area NEA.

In one or more embodiments, opposite side surfaces of the via layer VIA with the third contactor CTN3 formed therebetween may have an inclination angle θ4 ("gradient" or "inclination") substantially identical or similar to an inclination angle θ3 ("gradient" or "inclination") of opposite side surfaces of the first insulating layer INS1 with the second through hole TH2 formed therebetween. In this case, the opposite side surfaces of the first insulating layer INS1 (or an edge of the second through hole TH2) may correspond to (or match with) the opposite side surfaces of the via layer VIA (or an edge of the third contactor CNT3). In other words, the opposite side surfaces of the first insulating layer INS1 (or the edge of the second through hole TH2) may be located on the same line as the opposite side surfaces of the via layer VIA (or the edge of the third contactor CNT3).

The first insulating layer INS1 may be formed of an inorganic insulating layer made of inorganic material. For example, the first insulating layer INS1 may be formed of an inorganic insulating layer suitable for protecting the light emitting elements LD from the pixel circuit layer PCL. For instance, the first insulating layer INS1 may include at least one of silicon nitride (SiNₓ), silicon oxide (SiOₓ), silicon oxynitride (SiOₓN_{y}), and metal oxide such as aluminum oxide (AlOₓ).

In one or more embodiments, the first insulating layer INS1 may be provided in the form of a single layer or multilayer structure. In case that the first insulating layer INS1 is provided in the form of a multilayer structure, the first insulating layer INS1 may have a distributed Bragg reflector (DBR) structure formed by alternately stacking first layers and second layers that are formed of inorganic layers and have different refractive indexes.

The first bank BNK1 may be disposed on the first insulating layer INS1.

The first bank BNK1 may be provided and/or formed on the first insulating layer INS1 in the non-emission area NEA. The first bank BNK1 may enclose the emission area EMA of the pixel PXL, and may be formed between adjacent pixels PXL so that a pixel defining layer for defining the emission area EMA of the corresponding pixel PXL may be formed. At the step of supplying (or inputting) the light emitting elements LD to the emission area EMA, the first bank BNK1 may form a dam structure configured to prevent a solution (or ink) mixed with the light emitting elements LD from being drawn into the emission area EMA of an adjacent pixel PXL or control the amount of solution such that an appropriate amount of solution is supplied to each emission area EMA.

The first bank BNK1 may include at least one light block material and/or reflective material (or scattering material), thus preventing a light leakage defect in which light (or rays) leaks between the pixel PXL and the pixels PXL adjacent thereto. In one or more embodiments, the first bank BNK1 may include transparent material (or substance). The transparent material may include, for example, polyamides resin, polyimides resin, and the like, but embodiments of the present disclosure are not limited thereto. In one or more embodiments, in order to further enhance the efficiency of light emitted from the pixel PXL, a separate reflective material layer may be provided and/or formed on the first bank BNK1.

In one or more embodiments, the first bank BNK1 may be surface-treated so that at least one surface thereof has hydrophobicity. For example, the first bank BNK1 may be surface-treated to have hydrophobicity by plasma before the light emitting elements LD are aligned, but embodiments of the present disclosure are not limited thereto.

The light emitting elements LD may be supplied to the emission area EMA enclosed (or defined) by the first bank BNK1. For example, the light emitting elements LD may be supplied (or input) to the emission area EMA by an inkjet printing scheme or the like. The light emitting elements LD may be aligned on a surface of the first insulating layer INS1 between the first alignment electrode ALE1 (or a first alignment line that is before being separated into the first alignment electrode ALE1) and the second alignment electrode ALE2 by an electric field formed by certain signals (or alignment signals) applied to the first alignment electrode ALE1 and the second alignment electrode ALE2. For instance, the light emitting elements LD supplied to the emission area EMA may be arranged such that the first ends EP1 oppose the first alignment electrode ALE1, and the second ends EP2 oppose the second alignment electrodes ALE2.

The light emitting elements LD may include a first light emitting element LD1 and a second light emitting element LD2.

The first light emitting element LD1 may be disposed between the right side of the first alignment electrode ALE1 and one second alignment electrode ALE2 adjacent to the right side of the first alignment electrode ALE1. The first light emitting element LD1 may include a first end EP1 that opposes the right side of the first alignment electrode ALE1, and a second end EP2 that opposes the one second alignment electrode ALE2.

The second light emitting element LD2 may be disposed between the left side of the first alignment electrode ALE1 and another second alignment electrode ALE2 adjacent to the left side of the first alignment electrode ALE1. The second light emitting element LD2 may include a first end EP1 that opposes the left side of the first alignment electrode ALE1, and a second end EP2 that opposes the another second alignment electrode ALE2.

The second insulating layer INS2 may be provided and/or formed on each of the first and second light emitting elements LD1 and LD2. The second insulating layer INS2 may be disposed on each of the first and second light emitting elements LD1 and LD2, and partially cover an outer surface (e.g., an outer peripheral or circumferential surface or a surface) of each of the first and second light emitting elements LD1 and LD2 so that the first end EP1 and the second end EP2 of each of the first and second light emitting elements LD1 and LD2 may be exposed to the outside. The second insulating layer INS2 may be formed on the first insulating layer INS1 in the non-emission area NEA and may be partially open so that some components disposed thereunder can be exposed. For example, the second insulating layer INS1 may be partially open to include the first opening OPN1 corresponding to the first contact hole CH1 of the passivation layer PSV so that one area of the first conductive pattern CP1 can be exposed, and may be partially open to include the second opening OPN2 corresponding to the third contact hole CH3 of the passivation layer PSV so that another area of the second conductive pattern CP2 can be exposed.

The first opening OPN1 of the second insulating layer INS2, the first through hole TH1 of the first insulating layer INS1, the first contactor CNT1 of the via layer VIA, and the first contact hole CH1 of the passivation layer PSV may overlap each other in the non-emission area NEA. Furthermore, the second opening OPN2 of the second insulating layer INS2, the second through hole TH2 of the first insulating layer INS1, the third contactor CNT3 of the via layer VIA, and the third contact hole CH3 of the passivation layer PSV may overlap each other in the non-emission area NEA.

The second insulating layer INS2 may include an inorganic insulating layer including inorganic material, or an organic insulating layer. For example, the second insulating layer INS2 may include an inorganic insulating layer suitable for protecting the active layer 12 of each of the first and second light emitting elements LD1 and LD2 from external oxygen, water, or the like. However, embodiments of the present disclosure are not limited thereto. The second insulating layer INS2 may be formed of an organic insulating layer including organic material, depending on design conditions, etc. of the display device to which the first and second light emitting elements LD1 and LD2 are applied. The second insulating layer INS2 may be formed of a single layer or multiple layers.

Because the second insulating layer INS2 is formed on the first and second light emitting elements LD1 and LD2 that are completely aligned in the emission area EMA of each of the first, second, and third pixels PXL1, PXL2, and PXL3, the first and second light emitting elements LD1 and LD2 may be prevented from being removed from aligned positions.

Different electrodes from among the first electrode PE1, the second electrode PE2, and the intermediate electrode CTE may be formed on the opposite ends of the first and second light emitting elements LD1 and LD2, e.g., the first and second ends EP1 and EP2, which are not covered with the second insulating layer INS2. For example, the first electrode PE1 may be formed on the first end EP1 of the first light emitting element LD1. The intermediate electrode CTE may be formed on the second end EP2 of the first light emitting element LD1. The intermediate electrode CTE may be formed on the first end EP1 of the second light emitting element LD2. The second electrode PE2 may be formed on the second end EP2 of the second light emitting element LD2.

The first electrode PE1 may be disposed over the first alignment electrode ALE1 to overlap the right side of the first alignment electrode ALE1. The second electrode PE2 may be disposed over the second alignment electrode ALE2 to overlap the second alignment electrode ALE2 adjacent to the left side of the first alignment electrode ALE1. The intermediate electrode CTE may be disposed over each of the left side of the first alignment electrode ALE1 and the second alignment electrode ALE2 adjacent to the right side of the first alignment electrode ALE1.

In one or more embodiments, the first electrode PE1 may be brought into direct contact with and electrically connected to the first conductive pattern CP1 (or the second storage electrode UE) on the second node N2. The second electrode PE2 may be brought into direct contact with and electrically connected to another area of the second conductive pattern CP2 (or the second power line PL2) on the third node N3.

In one or more embodiments, the first electrode PE1, the intermediate electrode CTE, and the second pixel electrode PE2 may be formed at the same layer or different layers. For example, relative positions and/or a formation sequence of the first electrode PE1, the intermediate electrode CTE, and the second pixel electrode PE2 may be changed in various ways depending on embodiments.

In an embodiment of FIG. 8, the intermediate electrode CTE may be first formed on the second insulating layer INS2. The intermediate electrode CTE may directly contact the second end EP2 of the first light emitting element LD1 and the first end EP1 of the second light emitting element LD2 and thus may be electrically connected between the first light emitting element LD1 and the second light emitting element LD2. Thereafter, the third insulating layer INS3 may be formed in the emission area EMA such that the intermediate electrode CTE is covered with the third insulating layer INS3.

The third insulating layer INS3 may be disposed on the intermediate electrode CTE and thus cover the intermediate electrode CTE (or prevent the intermediate electrode CTE from being exposed to the outside), thus preventing corrosion or the like of the intermediate electrode CTE. Furthermore, the third insulating layer INS3 may be partially open so that components disposed thereunder are exposed. For example, the third insulating layer INS3 may be partially open to include the first via hole VIH1 corresponding to the first opening OPN1 of the second insulating layer INS2 so that one area of the first conductive pattern CP1 can be exposed, and may be partially open to include the second via hole VIH2 corresponding to the second opening OPN2 of the second insulating layer INS2 so that another area of the second conductive pattern CP2 can be exposed.

The first via hole VIH1 of the third insulating layer INS3, the first opening OPN1 of the second insulating layer INS2, the first through hole TH1 of the first insulating layer INS1, the first contactor CNT1 of the via layer VIA, and the first contact hole CH1 of the passivation layer PSV that overlap each other in the non-emission area NEA may form the second node N2 that is the first point that connects the pixel circuit PXC (or the pixel circuit layer PCL) of each pixel PXL with the emission component EMU (or the display element layer DPL) of the corresponding pixel PXL.

The second via hole VIH2 of the third insulating layer INS3, the second opening OPN2 of the second insulating layer INS2, the second through hole TH2 of the first insulating layer INS1, the third contactor CNT3 of the via layer VIA, and the third contact hole CH3 of the passivation layer PSV that overlap each other in the non-emission area NEA may form the third node N3 that is the second point that connects the pixel circuit PXC (or the pixel circuit layer PCL) of each pixel PXL with the emission component EMU (or the display element layer DPL) of the corresponding pixel PXL.

The third insulating layer INS3 may be formed of an inorganic insulating layer including inorganic material, or an organic insulating layer including organic material. For example, the third insulating layer INS3 may include at least one of silicon nitride (SiNₓ), silicon oxide (SiOₓ), silicon oxynitride (SiOₓN_{y}), and metal oxide such as aluminum oxide (AlOₓ), but embodiments of the present disclosure are not limited thereto. The third insulating layer INS3 may be formed of a single layer or multiple layers.

The first electrode PE1 and the second electrode PE2 may be formed on the third insulating layer INS3. The first electrode PE1 may directly contact the first end EP1 of the first light emitting element LD1. The second electrode PE2 may directly contact the second end EP2 of the second light emitting element LD2.

In an embodiment of FIG. 9, the first and second electrodes PE1 and PE2 may be first formed on the second insulating layer INS2. The first and second electrodes PE1 and PE2 may be concurrently (e.g., simultaneously) or successively formed. Thereafter, the third insulating layer INS3 may be formed to cover the first and second electrodes PE1 and PE2. The intermediate electrode CTE may be formed in the emission area EMA in which the third insulating layer INS3 has been formed.

As illustrated in the embodiments of FIGS. 8 and 9, in case that the electrodes disposed on the first end EP1 and the second end EP2 of each light emitting element LD are disposed on different layers, the electrodes may be reliably electrically separated from each other so that a short-circuit defect can be prevented from occurring between the electrodes.

In an embodiment of FIG. 10, the first electrode PE1, the intermediate electrode CTE, and the second electrode PE2 may be disposed at the same layer in the display element layer DPL, and may be concurrently (e.g., simultaneously) or sequentially formed. In this case, the third insulating layer INS3 may be omitted. In the embodiment of FIG. 10, in case that the electrodes disposed on the first end EP1 and the second end EP2 of each light emitting element LD are disposed at the same layer and concurrently (e.g., simultaneously) formed, a process of fabricating the pixel PXL may be facilitated, and the process efficiency may be enhanced.

The first electrode PE1, the second electrode PE2, and the intermediate electrode CTE may be formed of various transparent conductive materials to allow light emitted from each of the light emitting elements LD to travel in the image display direction (e.g., in the third direction DR3) of the display device DD without optical loss. For example, the first electrode PE1, the second electrode PE2, and the intermediate electrode CTE may include at least one of various transparent conductive materials including indium tin oxide (ITO), indium zinc oxide (IZO), zinc oxide (ZnOₓ), indium gallium zinc oxide (IGZO), and indium tin zinc oxide (ITZO), and may be substantially transparent or translucent to satisfy a certain transmittancy (or transmittance). The materials of the first electrode PE1, the second electrode PE2, and the intermediate electrode CTE are not limited to those of the foregoing embodiments. In one or more embodiments, the first electrode PE1, the second electrode PE2, and the intermediate electrode CTE may be formed of various opaque conductive materials (substances). Each of the first electrode PE1, the second electrode PE2, and the intermediate electrode CTE may be formed of a single layer or multiple layers.

In one or more embodiments, at least one overcoat layer (e.g., a layer for planarizing the upper surface of the display element layer DPL) may be further disposed over the first electrode PE1, the intermediate electrode CTE, and the second electrode PE2.

In one or more embodiments, an optical layer may be selectively disposed over the display element layer DPL of each pixel PXL. For example, the optical layer may further include a color conversion layer including color conversion particles for converting the color of light emitted from the light emitting elements LD to a specific color of light.

In the foregoing embodiment, the second storage electrode UE of the pixel circuit PXC (or the pixel circuit layer PCL) may directly contact the first electrode PE1 of the emission component EMU (or the display element layer DPL) on the second node N2 located in the non-emission area NEA and may be electrically connected to the first electrode PE1. Furthermore, the second power line PL2 of the pixel circuit PXC (or the pixel circuit layer PCL) may directly contact the second electrode PE2 of the emission component EMU (or the display element layer DPL) on the third node N3 located in the non-emission area NEA and may be electrically connected to the second electrode PE2.

Each of the storage electrode UE and the second power line PL2 may be formed of double layers stacked in a sequence of titanium/copper. If, as in the typical display device, the conductive layer formed by stacking layers in a sequence of titanium/copper directly contacts the alignment electrode formed of aluminum, the alignment electrode ALE formed of aluminum may be oxidized when a chemical solution (e.g., a developing solution) including the hydroxyl group (-OH) is applied to a contact surface between the conductive layer and the alignment electrode ALE during the fabrication process. Consequently, the alignment electrode ALE may be corroded. The corrosion may cause distortion resulting from a signal delay when a certain signal is applied to the alignment electrode ALE, so that an undesired defect may occur when the light emitting elements LD are aligned in the emission area EMA or the light emitting elements LD are driven.

To mitigate or minimize the defect, in the foregoing embodiment, the first electrode PE1 formed of transparent conductive oxide may directly contact the second storage electrode UE that is formed by stacking layers in a sequence of titanium/copper and is exposed through the first via hole VIH1 of the third insulating layer INS3, the first opening OPN1 of the second insulating layer INS2, the first through hole TH1 of the first insulating layer INS1, the first contactor CNT1 of the via layer VIA, and the first contact hole CH1 of the passivation layer PSV that are disposed on the second node N2 in the non-emission area NEA. The second electrode PE2 formed of transparent conducive oxide may directly contact the second power line PL2 that is formed of stacking layers of titanium/copper and is exposed through the second via hole VIH2 of the third insulating layer INS3, the second opening OPN2 of the second insulating layer INS2, the second through hole TH2 of the first insulating layer INS1, the third contactor CNT3 of the via layer VIA, and the third contact hole CH3 of the passivation layer PSV that are located on the third node N3 in the non-emission area NEA. Therefore, a direct contact between the alignment electrode ALE and each of the second storage electrode UE, the second power line PL2, the first electrode PE1, and the second electrode PE2 may be prevented, or a direct contact surface area therebetween may be reduced, so that the alignment electrode ALE may be prevented from being corroded, whereby the reliability of the alignment electrode ALE can be improved.

In the foregoing embodiment, on the second and third nodes N2 and N3, the first and second electrodes PE1 and PE2 respectively directly contact the second storage electrode UE and the second power line PL2 so that the first and second electrodes PE1 and PE2 and the alignment electrodes ALE can be prevented from directly contact each other (or being physically or electrically connected to each other). Therefore, the first and second electrodes PE1 and PE2 can be prevented from making direct contact with the alignment electrodes ALE that has a relatively large resistance due to material characteristics and/or oxidation or the like that occurs during the fabrication process. Hence, the contact resistance of the first and second electrodes PE1 and PE2 may be prevented from increasing. Therefore, the reliability of the first and second electrodes PE1 and PE2 may be enhanced, so that when a certain signal (or voltage) is supplied to the light emitting elements LD, distortion attributable to a signal delay may be mitigated or minimized, whereby the light emitting elements LD may be more reliably driven.

In addition, in the foregoing embodiment, because among the components disposed on the second node N2, the opposite side surfaces of the via layer VIA that oppose each other with the first contactor CNT1 interposed therebetween may correspond to (or be collinear with) the opposite surfaces of the first insulating layer INS1 that oppose each other with the first through hole TH1 interposed therebetween, the second and third insulating layers INS2 and INS3 that cover the opposite side surfaces of each of the via layer VIA and the first insulating layer INS1 may have even surfaces without including a stepped portion. Hence, a disconnection phenomenon of the first electrode PE1 that may be caused when the first electrode PE1 is formed on the second and third insulating layers INS2 and INS3 may be prevented so that the first electrode PE1 and the second storage electrode UE can be more reliably connected to each other on the second node N2.

In addition, in the foregoing embodiment, because among the components disposed on the third node N3, the opposite side surfaces of the via layer VIA that oppose each other with the third contactor CNT3 interposed therebetween may correspond to (or be collinear with) the opposite surfaces of the first insulating layer INS1 that oppose each other with the second through hole TH2 interposed therebetween, the second and third insulating layers INS2 and INS3 that cover the opposite side surfaces of each of the via layer VIA and the first insulating layer INS1 may have even surfaces without including a stepped portion. Hence, a disconnection phenomenon of the second electrode PE2 that may be caused when the second electrode PE2 is formed on the second and third insulating layers INS2 and INS3 may be prevented so that the second electrode PE2 and the second power line PL2 can be more reliably connected to each other on the third node N3.

Furthermore, in the foregoing embodiment, in at least the non-emission area NEA, a connection point between the second alignment electrode ALE2 and the second power line PL2 (e.g., a point including the second contactor CNT2 of the via layer VIA and the second contact hole CH2 of the passivation layer PSV) and a connection point between the floating pattern FPT (or the first alignment electrode ALE1) and the first power line PL1 (e.g., a point including the fourth contactor CNT4 of the via layer VIA and the fourth contact hole CH4 of the passivation layer PSV) may be enclosed by the first bank BNK1. Therefore, a phenomenon in which a signal applied to each of the connection point between the second alignment electrode ALE2 and the second power line PL2 and the connection point between the floating pattern FPT and the first power line PL1 influences an electric field formed between the alignment electrodes ALE at the step of aligning the light emitting elements LD may be mitigated or minimized.

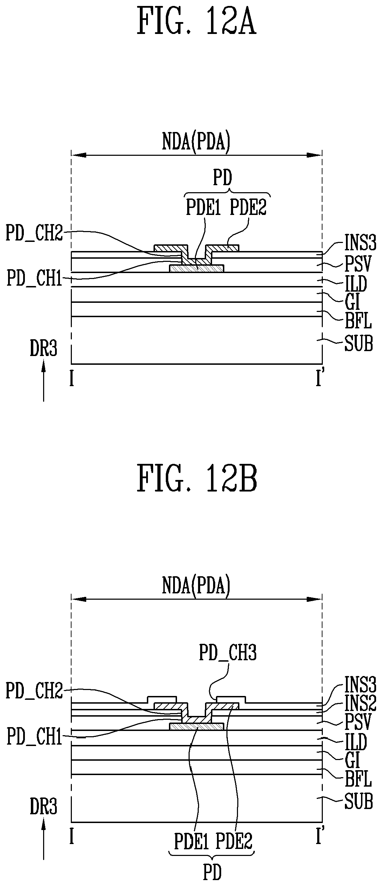

FIGS. 12A and 12B are schematic cross-sectional views taken along the line I-I' of FIG. 3.

FIGS. 12A and 12B illustrate different modifications of an embodiment pertaining to a position of a second pad electrode PDE2. For example, FIG. 12A illustrates an embodiment in which the second pad electrode PDE2 is disposed on the third insulating layer INS3. FIG. 12B illustrates an embodiment in which the second pad electrode PDE2 is disposed on the second insulating layer INS2.

The description with reference to FIGS. 12A and 12B will be focused on differences from the above-mentioned embodiments so as to avoid redundant description. Components that are not separately explained in the following description of the embodiment of FIGS. 12A and 12B comply with that of the foregoing embodiments. The same reference numeral will be used to designate the same component, and a similar reference numeral will be used to designate a similar component.

Referring to FIGS. 1 and 12B, each of the pads PD disposed or located in the non-display area NDA may include a first pad electrode PDE1 and a second pad electrode PDE2.

The first pad electrode PDE1 may correspond to the third conductive layer disposed on the interlayer insulating layer ILD. The interlayer insulating layer ILD may have the same configuration as that of the interlayer insulating layer ILD described with reference to FIGS. 7A, 7B, and 8, so that detailed explanation thereof will be omitted.

The first pad electrode PDE1 may be provided or disposed on the interlayer insulating layer ILD, and may be provided at the same layer as the first, second, and third conductive patterns CP1, CP2, and CP3 (or the second storage electrode UE, the second power line PL2, and the first power line PL1) described with reference to FIGS. 7A, 7B, and 8, and may have the same material as that of the first, second, and third conductive patterns CP1, CP2, and CP3. In one or more embodiments, the first pad electrode PDE1 may be formed of double layers stacked in a sequence of titanium/copper.

The passivation layer PSV may be disposed on the first pad electrode PDE1 and the interlayer insulating layer ILD. The passivation layer PSV may be a passivation layer PSV described with reference to FIGS. 7A, 7B, and 8.

The passivation layer PSV may be partially open so that a portion of the first pad electrode PDE1 in the pad area PDA may be exposed. For example, the passivation layer PSV may be partially open to include a first pad electrode contact hole PD_CH1 through which a portion of the first pad electrode PDE1 is exposed in at least the non-display area NDA.

In an embodiment of FIG. 12A, the third insulating layer INS3 may be disposed on the passivation layer PSV. The third insulating layer INS3 may be the third insulating layer INS3 described with reference to FIGS. 7A, 7B, and 8. The third insulating layer INS3 may be partially open to include a second pad electrode contact hole PD_CH2 corresponding to the first pad electrode contact hole PD_CH1. The second pad electrode PDE2 may be disposed on the third insulating layer INS3. The second pad electrode PDE2 may be disposed on the third insulating layer INS3, directly contact the first pad electrode PDE1 exposed through the first and second pad electrode contact holes PD_CH1 and PD_CH2, and may be electrically connected to the first pad electrode PDE1. The second pad electrode PDE2 may be provided at the same layer as the first and second electrodes PE1 and PE2 described with reference to FIGS. 7A, 7B, and 8, and include the same material as that of the first and second electrodes PE1 and PE2. For example, the second pad electrode PDE2 may be formed through the same process as the first and second electrodes PE1 and PE2. In the embodiment of FIG. 12A, the via layer VIA, the first insulating layer INS1, and the second insulating layer INS2 may not be disposed (or may be omitted) between the first pad electrode PDE1 and the second pad electrode PDE2.

In the embodiment of FIG. 12B, the second insulating layer INS2 may be disposed on the passivation layer PSV. The second insulating layer INS2 may be the second insulating layer INS2 described with reference to FIGS. 7A, 7B, and 8. The second insulating layer INS2 may be partially open to include a second pad electrode contact hole PD_CH2 corresponding to the first pad electrode PD_CH1. The second pad electrode PDE2 may be disposed on the second insulating layer INS2. The second pad electrode PDE2 may be disposed on the second insulating layer INS3, directly contact the first pad electrode PDE1 exposed through the first and second pad electrode contact holes PD_CH1 and PD_CH2, and be electrically connected to the first pad electrode PDE1. The second pad electrode PDE2 may be provided at the same layer as the intermediate electrode CTE described with reference to FIGS. 7A, 7B, and 8, and include the same material as that of the intermediate electrode CTE. For example, the second pad electrode PDE2 may be formed through the same process as the intermediate electrode CTE. The third insulating layer INS3 may be disposed on the second pad electrode PDE2. The third insulating layer INS3 may be partially open to include a third pad electrode contact hole PD_CH3 through which the second pad electrode PDE2 is exposed. In the embodiment of FIG. 12B, the via layer VIA and the first insulating layer INS1 may not be disposed (or may be omitted) between the first pad electrode PDE1 and the second pad electrode PDE2.

In embodiments of FIGS. 12A and 12B, the second pad electrode PDE2 may be formed of transparent conductive oxide such as indium tin oxide (ITO), indium zinc oxide (IZO), zinc oxide (ZnO), indium gallium zinc oxide (IGZO), and indium tin zinc oxide (ITZO). The second pad electrode PDE2 may be exposed to the outside and electrically connected to a driver by a conductive adhesive or the like.

In the foregoing embodiment, the first pad electrode PDE1 that is formed by stacking layers in a sequence of titanium/copper and exposed through the first and second pad electrode contact holes PD_CH1 and PD_CH2 may directly contact the second pad electrode PDE2 formed of transparent conductive oxide, so that the first pad electrode PDE1 can be prevented from directly contacting any conductive layer formed of aluminum. Because the first pad electrode PDE1 is prevented from being connected to any conductive layer formed of aluminum, corrosion can be prevented from occurring between the conductive layer and the first pad electrode PDE1 during the fabrication process. Consequently, the reliability of each of the pads PD may be improved.

Furthermore, in the foregoing embodiment, some insulating layers that are disposed between the first pad electrode PDE1 and the second pad electrode PDE2 may be omitted, so that the number of insulating layers between the first pad electrode PDE1 and the second pad electrode PDE2 may be reduced or minimized, whereby a defect attributable to a clad step difference which may occur when a conductive component (e.g., a conductive ball) and the pads PD are electrically connected to each other may be mitigated or minimized.

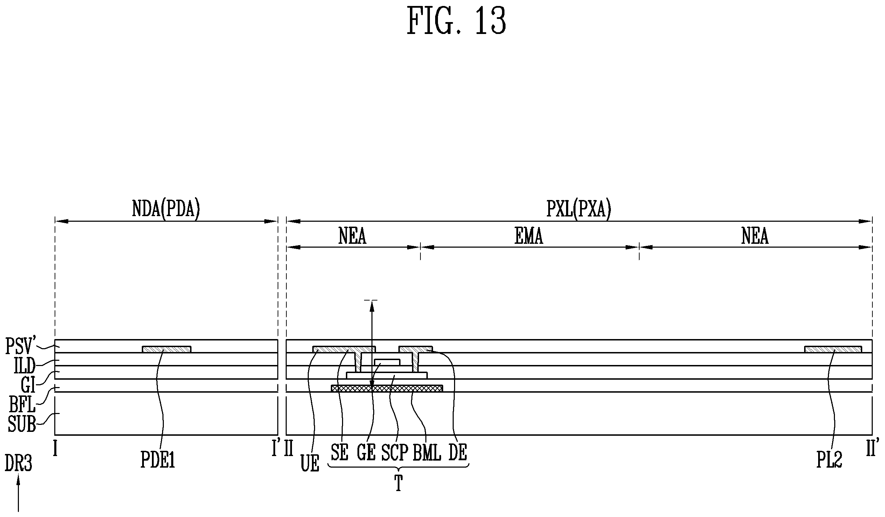

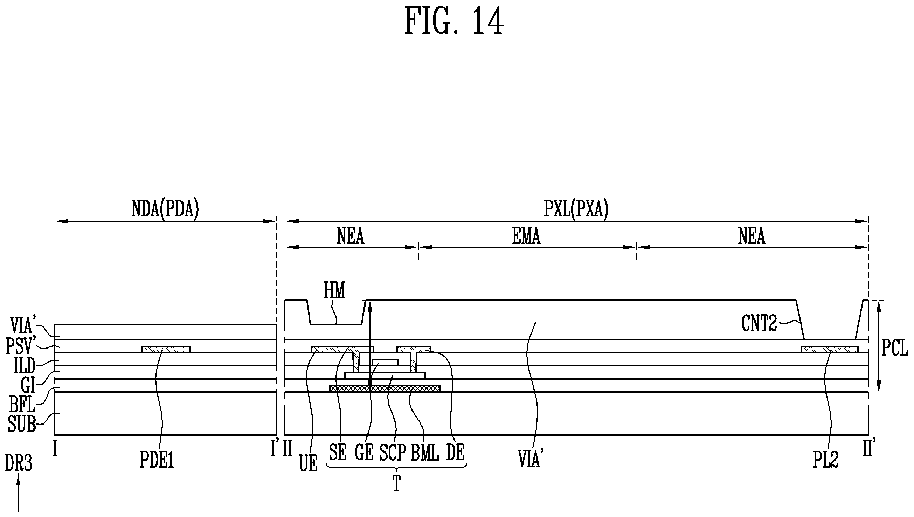

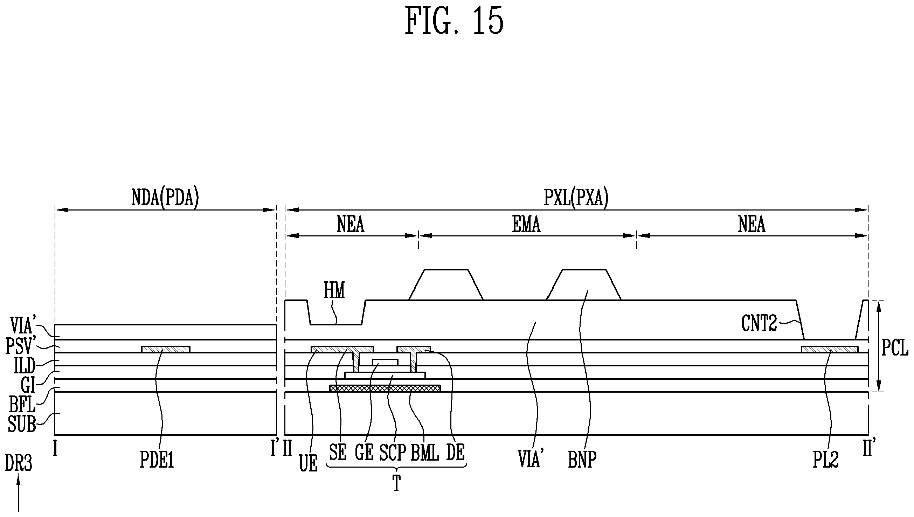

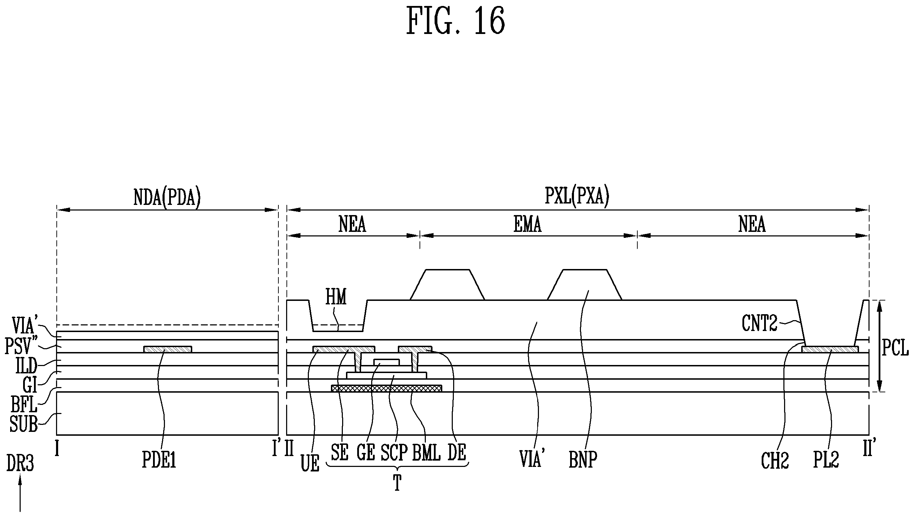

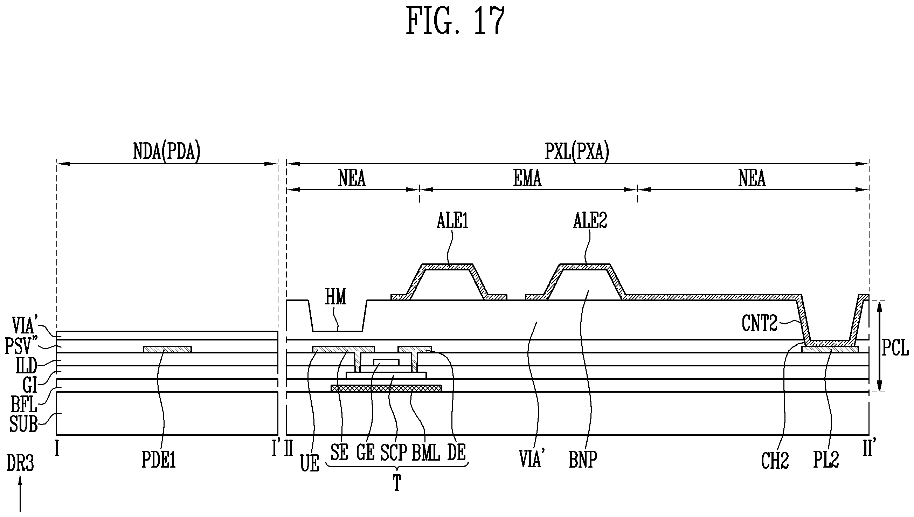

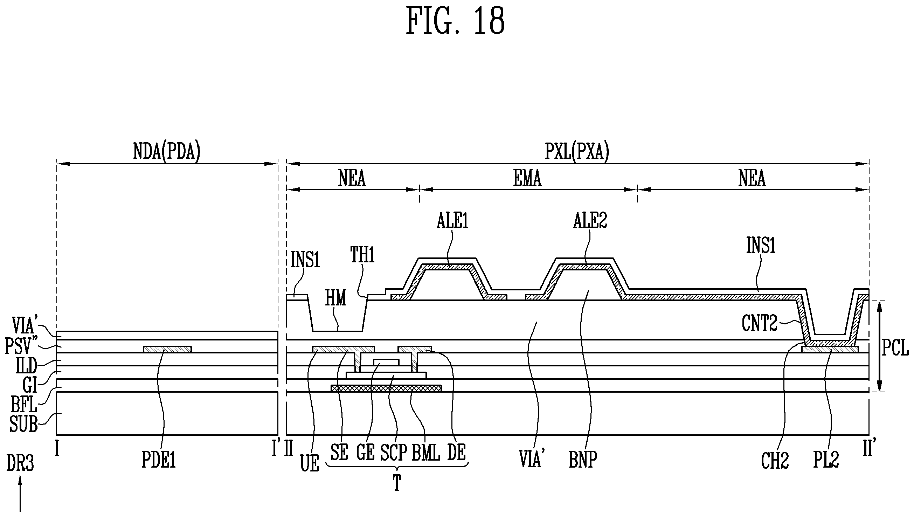

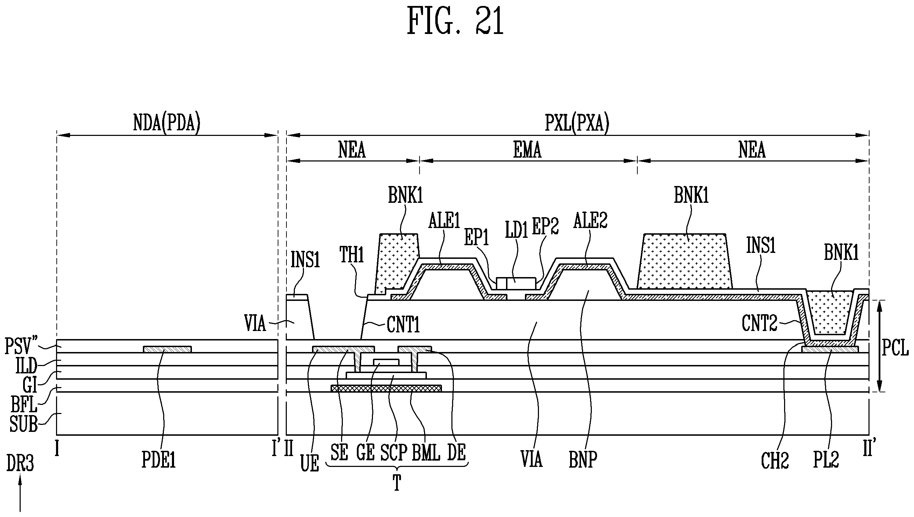

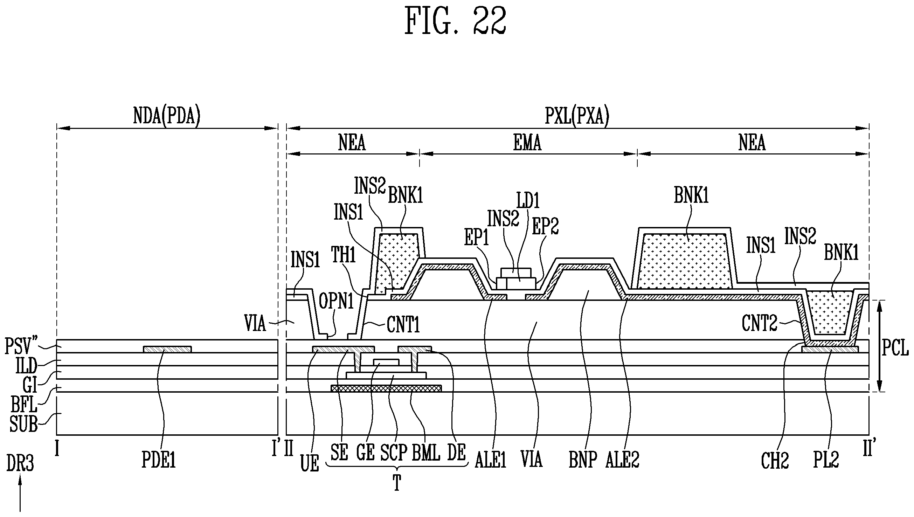

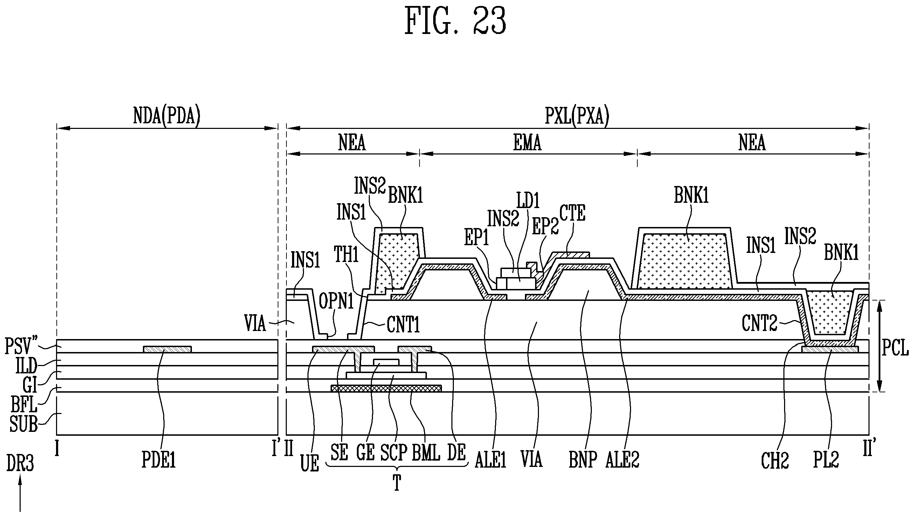

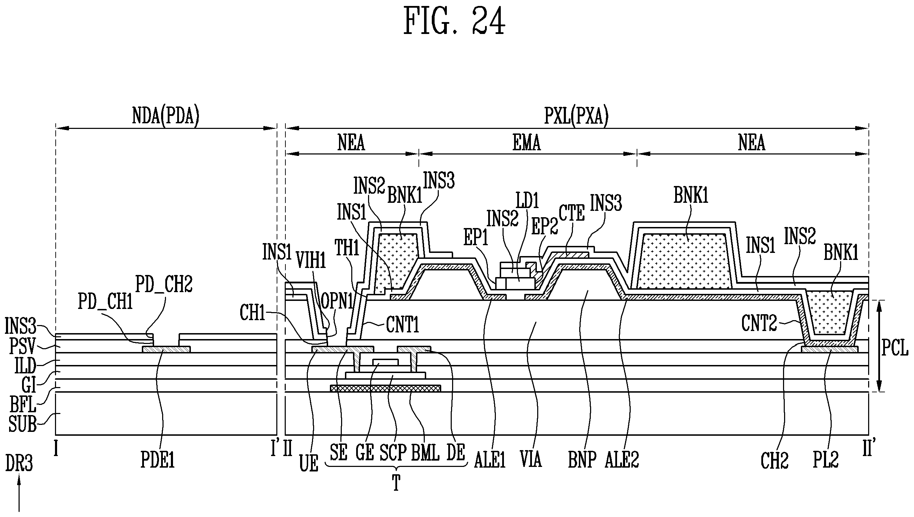

FIGS. 13 to 24 are views sequentially illustrating a method of fabricating the display device DD in accordance with one or more embodiments, and are schematic cross-sectional views taken along the line I-I' of FIG. 3 and the line II-II' of FIG. 6.

Hereinafter, the method of fabricating the display device DD in accordance with one or more embodiments will be sequentially described with reference to FIGS. 13 to 24.

Herein, there is illustrated the case where the steps of fabricating the pixel PXL are sequentially performed according to the sectional views, but some steps illustrated as being successively performed may be concurrently (e.g., simultaneously) performed, the sequence of the steps may be changed, some steps may be skipped, or another step may be further included between the steps.

The description with reference to FIGS. 13 to 24 will be focused on differences from the above-mentioned embodiments so as to avoid redundant description.

Referring to FIGS. 1 to 13, the transistor T, the second storage electrode UE, and the second power line PL2 are formed on the substrate SUB in the pixel area PXA (or the display area DA). The first pad electrode PDE1 is formed on the substrate SUB in the pad area PDA (or the non-display area NDA).

The source electrode SE and the drain electrode DE of the transistor T, the second power line PL2, and the first pad electrode PDE1 may be formed through the same process, may be disposed at the same layer, and include the same material.

A first insulating material layer PSV' is formed on the source electrode SE, the drain electrode DE, the second power line PL2, and the first pad electrode PDE1. The first insulating material layer PSV' may be a base material of the passivation layer PSV.

Referring to FIGS. 1 to 14, a second insulating material layer VIA' (or a via material layer) is formed on the first insulating material layer PSV'. The second insulating material layer VIA' may be formed through a photolithography process using a halftone mask, and may be a base material of the via layer VIA. The second insulating material layer VIA' may be partially open to include a stepped portion HM disposed on the first insulating material layer PSV' on the second storage electrode UE, and the second contactor CNT2 through which the first insulating material layer PSV' on the second power line PL2 is exposed.

Referring to FIGS. 1 to 15, the bank patterns BNP spaced from each other are formed on one surface of the second insulating material layer VIA'.

Referring to FIGS. 1 to 16, a dry etching process is performed to form a first insulating pattern PSV" including the second contact hole CH2 through which one area of the second power line PL2 that is disposed under the second contactor CNT2 at a position corresponding to the second contactor CNT2 is exposed.

During the foregoing process, a portion of the second insulating material layer VIA' of the pad area PDA may be removed, and a portion of the second insulating material layer VIA' on the second storage electrode UE may be removed. Hence, the stepped portion HM may be disposed more closely to the first insulating pattern PSV".

Referring to FIGS. 1 to 17, the first alignment electrode ALE1 and the second alignment electrode ALE2 are formed on the bank patterns BNP and the second insulating material layer VIA'.

The first and second alignment electrodes ALE1 and ALE2 may be formed on the bank patterns BNP and the second insulating material layer VIA' at least in the emission area EMA. The first and second alignment electrodes ALE1 and ALE2 may be formed of opaque metal including metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. For example, the first and second alignment electrodes ALE1 and ALE2 may be formed of opaque metal including aluminum (Al).

The second alignment electrode ALE2 may be brought into direct contact with and connected to the second power line PL2 through the second contactor CNT2 and the second contact hole CH2.

Referring to FIGS. 1 to 18, after an insulating material layer is applied to the overall surfaces of the alignment electrodes ALE, the bank patterns BNP, and the second insulating material layer VIA', a photo lithography process using a mask is performed, thus forming the first insulating layer INS1 that is partially open such that some components disposed thereunder are exposed. For example, the first insulating layer INS1 may be partially open to include the first through hole TH1 through which the stepped portion HM is exposed in the non-emission area NEA of the pixel area PXA. Furthermore, the first insulating layer INS1 may be open so that the entirety of the second insulating material layer VIA' in the pad area PDA can be exposed. In other words, the first insulating layer INS1 may not be disposed (or may be omitted) in the pad area PDA.

Referring to FIGS. 1 to 19, the stepped portion HM is completely removed from the non-emission area NEA of the pixel area PXA by performing an ashing process using oxygen plasma, so that the via layer VIA including the first contactor CNT1 through which the first insulating pattern PSV" disposed under the stepped portion HM is exposed can be formed.

Here, the opposite side surfaces of the via layer VIA that face each other with the first contactor CNT1 interposed therebetween (or the edge of the first contactor CNT1) may substantially correspond to (or match with) the opposite side surfaces of the first insulating layer INS1 that face each other with the first through hole TH1 interposed therebetween (or the edge of the first through hole TH1). For example, the opposite side surfaces of the via layer VIA may be disposed on the same lines as the opposite side surfaces of the first insulating layer INS1. Therefore, the opposite side surfaces of the via layer VIA with the first contactor CTN1 formed therebetween may have an inclination angle θ2 substantially identical or similar to an inclination angle θ1 of opposite side surfaces of the first insulating layer INS1 with the first through hole TH1 formed therebetween.

Furthermore, the second insulating material layer VIA' is completely removed from the pad area PDA through the ashing process, so that the first insulating pattern PSV" disposed under the second insulating material layer VIA' can be exposed.

Referring to FIGS. 1 to 20, the first bank BNK1 is formed on the first insulating layer INS1.

The first bank BNK1 may be disposed on the second contactor CNT2 of the via layer VIA and the second contact hole CH2 of the first insulating pattern PSV" and cover the second contactor CNT2 and the second contact hole CH2. Hence, the second contactor CNT2 of the via layer VIA and the second contact hole CH2 of the first insulating pattern PSV" that correspond to the connection point between the second alignment electrode ALE2 and the second power line PL2 may be covered with the first bank BNK1, thus being prevented from being exposed to the outside.

Referring to FIGS. 1 to 21, an electric field is formed between the first alignment electrode ALE1 and the second alignment electrode ALE2 by respectively applying corresponding alignment signals (or alignment voltages) to the first and second alignment electrodes ALE1 and ALE2.

Thereafter, after the electric field has been formed, ink including the first light emitting elements LD1 is input to the pixel area PXA through an inkjet printing scheme or the like. For example, at least one inkjet nozzle may be disposed on the first insulating layer INS1, and ink mixed with a plurality of first light emitting elements LD1 may be input to the pixel area PXA through the inkjet nozzle. Self-alignment of the first light emitting elements LD1 may be induced on the first insulating layer INS1 between the first alignment electrode ALE1 and the second alignment electrode ALE2.

After the first light emitting elements LD1 are self-aligned, a solvent included in the ink may be removed by a volatilization scheme or other schemes.

Referring to FIGS. 1 to 22, after an insulating material layer is applied to the overall surfaces of the first light emitting elements LD1, the first bank BNK1, and the first insulating layer INS1, a photo lithography process using a mask is performed, thus forming the second insulating layer INS2 that is partially open such that some components disposed thereunder are exposed. For example, the second insulating layer INS2 may be partially open to include the first opening OPN1, which is located in the first contactor CNT1 of the via layer VIA in the non-emission area NEA of the pixel area PXA, and through which one area of the first insulating pattern PSV" exposed through the first contactor CNT1 is exposed. Furthermore, the second insulating layer INS2 may be partially open to expose the first end EP1 and the second end EP2 of the first light emitting element LD1 in the emission area EMA of the pixel area PXA. Furthermore, the second insulating layer INS2 may be open so that the entirety of the first insulating pattern PSV" in the pad area PDA may be exposed. In other words, the second insulating layer INS2 may not be disposed (or may be omitted) in the pad area PDA.

Referring to FIG. 1 to 23, the intermediate electrode CTE is formed in the emission area EMA of the pixel area PXA. The intermediate electrode CTE may be disposed on the second ends EP2 of the first light emitting elements LD1 in the emission area EMA, and thus electrically connected with the first light emitting elements LD1.

Referring to FIGS. 1 to 24, after an insulating material layer is applied to the overall surfaces of the intermediate electrode CTE and the second insulating layer INS2, a photo lithography process using a mask is performed, thus forming the third insulating layer INS3 that is partially open such that some components disposed thereunder are exposed. Furthermore, during the foregoing process, a portion of the first insulating pattern PSV" is removed, so that the passivation layer PSV, including the first contact hole CH1 through which the second storage electrode UE is exposed and the first pad electrode contact hole PD_CH1 through which the first pad electrode PDE1 is exposed, may be formed.

The third insulating layer INS3 may be partially open to include the first via hole VIH1 that is located in the first contactor CNT1 of the via layer VIA in the non-emission area NEA and corresponds to the first opening OPN1 of the second insulating layer INS2. Furthermore, the third insulating layer INS3 may be partially open to include a second pad electrode contact hole PD_CH2 through which the first pad electrode PDE1 is exposed in the pad area PDA.

The passivation layer PSV may be partially open to include the first contact hole CH1 corresponding to the first via hole VIH1 of the third insulating layer INS3 in the non-emission area NEA of the pixel area PXA. Furthermore, the passivation layer PSV may be partially open to include the first pad electrode contact hole PD_CH1 corresponding to the second pad electrode contact hole PD_CH2 of the third insulating layer INS3 in the pad area PDA.

The first contact hole CH1 of the passivation layer PSV, the first opening OPN1 of the second insulating layer INS2, and the first via hole VIH1 of the third insulating layer INS3 may correspond to each other.

In the non-emission area NEA of each pixel PXL, the second storage electrode UE may be exposed to the outside through the first via hole VIH1 of the third insulating layer INS3, the first opening OPN1 of the second insulating layer INS2, the first through hole TH1 of the first insulating layer INS1, the first contactor CNT1 of the via hole VIH1, and the first contact hole CH1 of the passivation layer PSV.

Thereafter, the first electrode PE1 is formed on the first ends EP1 of the first light emitting elements LD1, the first insulating layer INS1, the third insulating layer INS3, and the exposed second storage electrode UE. The first electrode PE1 may be brought into direct contact with and connected to the second storage electrode UE through the first via hole VIH1 of the third insulating layer INS3, the first opening OPN1 of the second insulating layer INS2, the first through hole TH1 of the first insulating layer INS1, the first contactor CNT1 of the via hole VIH1, and the first contact hole CH1 of the passivation layer PSV.

The first via hole VIH1 of the third insulating layer INS3, the first opening OPN1 of the second insulating layer INS2, the first through hole TH1 of the first insulating layer INS1, the first contactor CNT1 of the via hole VIH1, and the first contact hole CH1 of the passivation layer PSV may be located on the second node N2 which is a point at which the first electrode PE1 and the second storage electrode UE are electrically connected to each other.

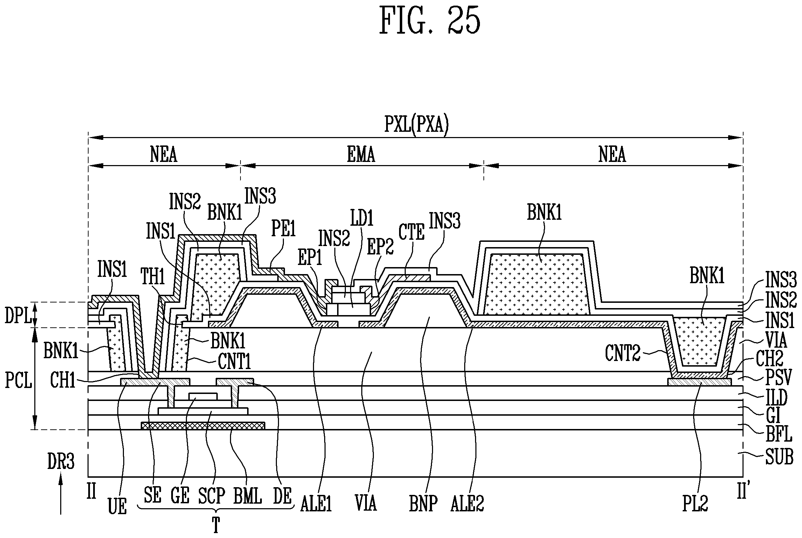

FIG. 25 is a schematic cross-sectional view illustrating a pixel PXL in accordance with one or more embodiments, and is a schematic sectional view taken along the line II-II' of FIG. 6.

The following description with reference to FIG. 25 will be focused on differences from that of the foregoing embodiments to avoid redundant explanation.

Referring to FIGS. 1 to 6, and 25, the opposite side surfaces of the via layer VIA that oppose each other with the first contactor CNT1 formed therebetween and the opposite side surfaces of the first insulating layer INS1 that oppose each other with the first through hole TH1 formed therebetween may be enclosed by the first bank BNK1.

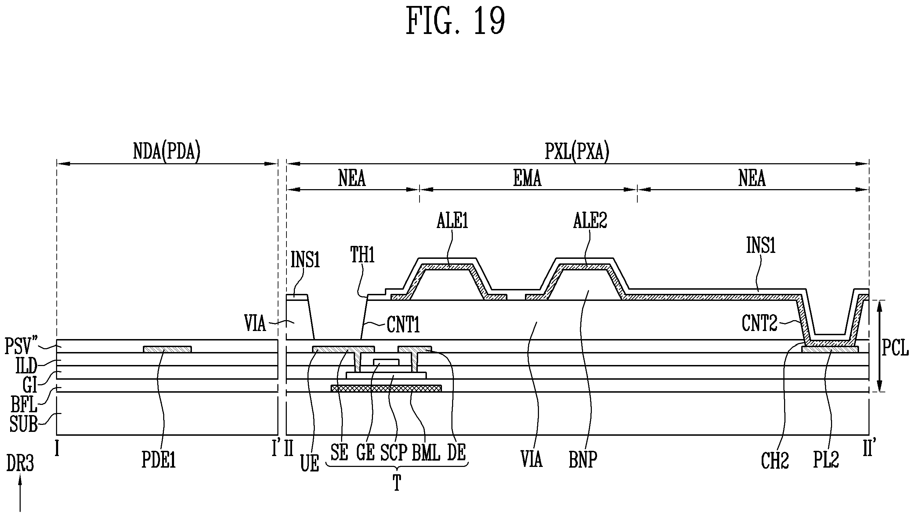

In the case in which the via layer VIA is excessively etched during the ashing process described with reference to FIG. 19, the opposite sides of the via layer VIA with the first contactor CNT1 formed therebetween (or the edge of the first contactor CNT1) may be located more inside than the opposite side surfaces of the first insulating layer INS1 with the first through hole TH1 formed therebetween (or the edge of the first through hole TH1). Therefore, the opposite sides of the via layer VIA (or the edge of the first contactor CNT1) and the opposite side surfaces of the first insulating layer INS1 (or the edge of the first through hole TH1) may not correspond to (or may not match with) each other. Hence, the second and third insulating layers INS2 and INS3 that cover the opposite side surfaces of the via layer VIA and the opposite side surfaces of the first insulating layer INS1 may form a stepped portion, thus forming an uneven surface. In the case where the second and third insulating layers INS2 and INS3 have an uneven surface, a disconnection phenomenon of the first electrode PE1 may be caused when the first electrode PE1 is formed on the second and third insulating layers INS2 and INS3. As a result, a defect in which the second storage electrode UE and the first electrode PE1 do not contact each other on the second node N2 may occur.

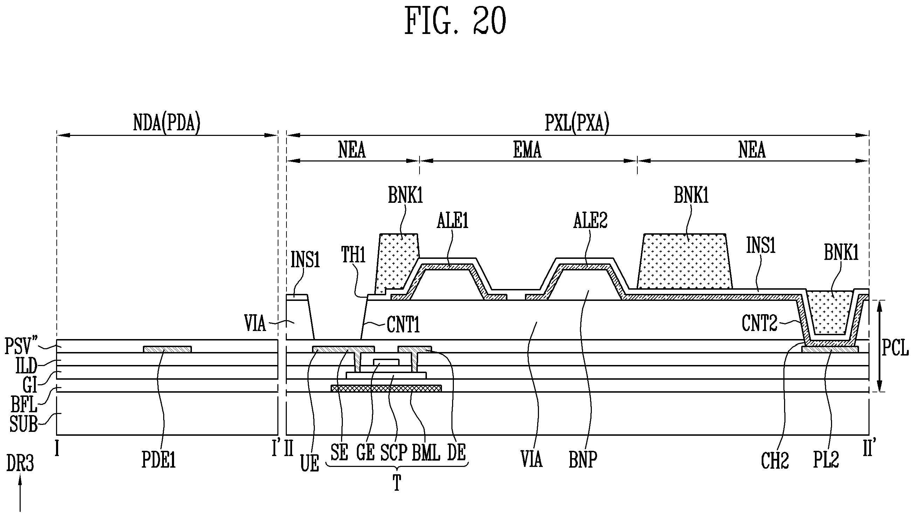

To prevent the above-mentioned defect from occurring, during a process of forming the first bank BNK1 described with reference to FIG. 20, the first bank BNK1 may be formed both on the opposite side surfaces of the via layer VIA that oppose each other with the first contactor CNT1 formed therebetween, and on the opposite side surfaces of the first insulating layer INS1 oppose face each other with the first through hole TH1 formed therebetween. The first bank BNK1 may have an overall uniform side surface, e.g., a smooth, side surface, which cover the opposite side surfaces of the via layer VIA (or the edge of the first contactor CNT1) and the opposite side surfaces of the first insulating layer INS1 (the edge of the first through hole TH1). In the case in which the second and third insulating layers INS2 and INS3 are formed on the first bank BNK1 having a smooth side surface, the second and third insulating layers INS2 and INS3 may have an even surface without including a stepped portion. Hence, a disconnection phenomenon of the first electrode PE1 that may be caused when the first electrode PE1 is formed on the second and third insulating layers INS2 and INS3 may be prevented so that the first electrode PE1 and the second storage electrode UE may be more reliably and electrically connected to each other on the second node N2.

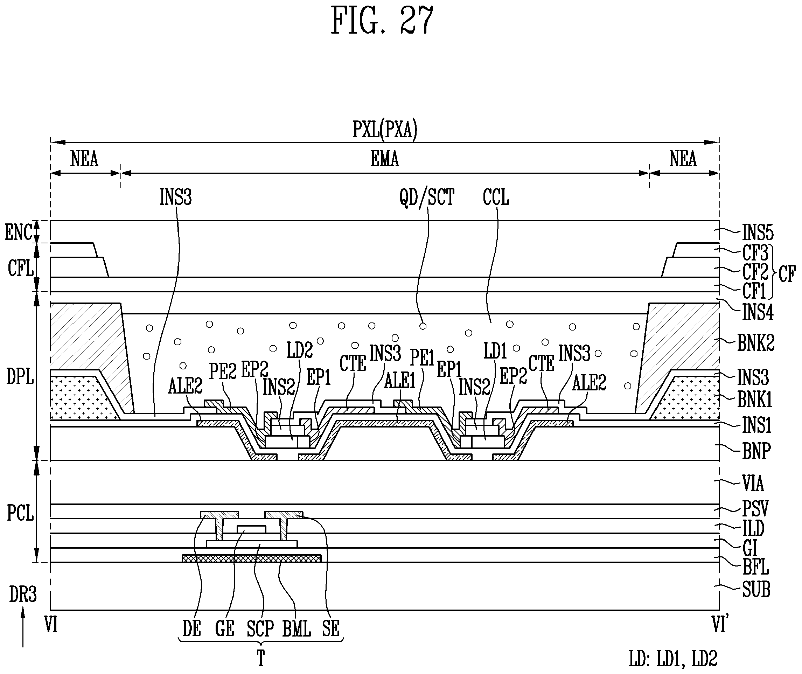

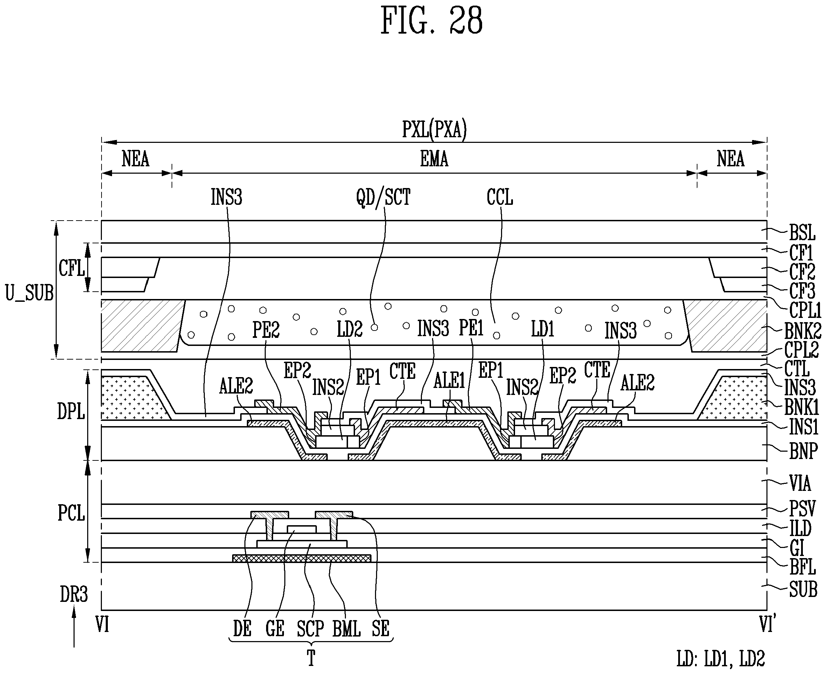

FIG. 26 is a plan view schematically illustrating a pixel area including an optical layer LCL in the pixel PXL illustrated in FIG. 3. FIGS. 27 and 28 are schematic cross-sectional views taken along the line VI-VI' of FIG. 26.

FIGS. 27 to 28 illustrate different modification examples with regard to the position of a color conversion layer CCL. For example, FIG. 27 illustrates an embodiment in which the color conversion layer CCL and a color filter CF are disposed over the first and second electrodes PE1 and PE2 through a successive process. FIG. 28 illustrates an embodiment in which an upper substrate U_SUB including the color conversion layer CCL and the color filter CF is disposed on the display element layer DPL through an adhesive process using an intermediate layer CTL.

The following description related to embodiments of FIGS. 26 to 28 will be focused on differences from the above-mentioned embodiments so as to avoid redundant description.

Referring to FIGS. 1 to 28, the optical layer LCL of the pixel PXL may include a first color filter CF1 and a color conversion layer CCL that are disposed or located in the emission area EMA, and a second bank BNK2 disposed or located in the non-emission area NEA.

The second bank BNK2 may be provided and/or formed on the first bank BNK1 in the non-emission area NEA of the pixel PXL. The second bank BNK2 may be a dam structure that encloses the emission area EMA of the pixel PXL and defines a position at which the color conversion layer CCL is to be supplied, thus eventually defining the emission area EMA.

The second bank BNK2 may include light shielding material. For example, the second bank BNK2 may be a black matrix. In one or more embodiments, the second bank BNK2 may include at least one light shielding material and/or reflective material, and allow light emitted from the color conversion layer CCL to more reliably travel in the image display direction of the display device DD, thus enhancing the light output efficiency of the color conversion layer CCL.

The color conversion layer CCL may be formed on (or over) the first electrode PE1, the intermediate electrode CTE, and the second electrode PE2 of each pixel PXL in the emission area EMA that is enclosed by the second bank BNK2.

The color conversion layer CCL may include color conversion particles QD corresponding to a specific color. For example, the color conversion layer CCL may include color conversion particles QD that convert a first color of light emitted from the light emitting elements LD1 and LD2 to a second color (or a specific color) of light different from the first color of light.

In the case in which the pixel PXL is a red pixel (or a red sub-pixel), the color conversion layer CCL of the pixel PXL may include color conversion particles QD formed of red quantum dots that convert a first color of light emitted from the light emitting elements LD1 and LD2 to a second color of light (e.g., red light).

In the case in which the pixel PXL is a green pixel (or a green sub-pixel), the color conversion layer CCL of the pixel PXL may include color conversion particles QD formed of green quantum dots that convert a first color of light emitted from the light emitting elements LD1 and LD2 to a second color of light (e.g., green light).

In the case in which the pixel PXL is a blue pixel (or a blue sub-pixel), the color conversion layer CCL of the pixel PXL may include color conversion particles QD formed of blue quantum dots that convert a first color of light emitted from the light emitting elements LD1 and LD2 to a second color of light (e.g., blue light). In the case in which the pixel PXL is a blue pixel (or a blue sub-pixel), in one or more embodiments, there may be provided a light scattering layer having light scattering particles SCT, in place of the color conversion layer CCL having the color conversion particles QD. For example, in the case in which the light emitting elements LD1 and LD2 emit blue-based light, the pixel PXL may include a light scattering layer including light scattering particles SCT. The light scattering layer may be omitted depending on embodiments. In the case in which the pixel PXL is a blue pixel (or a blue sub-pixel), in one or more embodiments, there may be provided a transparent polymer, in place of the color conversion layer CCL.

A fourth insulating layer INS4 may be disposed both on the color conversion layer CCL located in the emission area EMA and on the second bank BNK2 disposed in the non-emission area NEA.

The fourth insulating layer INS4 may be provided or located on the overall surface of the display area DA, in which the pixel PXL is disposed, to cover the second bank BNK2 and the color conversion layer CCL. The fourth insulating layer INS4 may be directly disposed on the second bank BNK2 and the color conversion layer CCL.

The fourth insulating layer INS4 may be an inorganic insulating layer including inorganic material. The fourth insulating layer INS4 may include at least one of silicon nitride (SiNₓ), silicon oxide (SiOₓ), silicon oxynitride (SiOₓN_{y}), and metal oxide such as aluminum oxide (AlOₓ). The fourth insulating layer INS4 may cover the entirety of the second bank BNK2 and the color conversion layer CCL and thus prevent external water or moisture from being drawn into the display element layer DPL.

The fourth insulating layer INS4 may mitigate a step difference formed by components disposed thereunder and have a planar surface. For example, the fourth insulating layer INS4 may include an organic insulating layer including organic material. The fourth insulating layer INS4 may be a common layer provided in common in the display area DA, but embodiments of the present disclosure are not limited thereto.

In the embodiment of FIG. 27, a color filter layer CFL may be provided and/or formed on the fourth insulating layer INS4. The color filter layer CFL may include a color filter CF corresponding to each pixel PXL. For example, the color filter layer CFL may include a first color filter CF1 disposed on the color conversion layer CCL of one pixel PXL (hereinafter, referred to as "first pixel"), a second color filter CF2 disposed on the color conversion layer of an adjacent pixel (hereinafter, referred to as "second pixel") adjacent to the first pixel PXL, and a third color filter CF3 disposed on the color conversion layer of an adjacent pixel (hereinafter, referred to as "third pixel") adjacent to the second pixel.

The first, second, and third color filters CF1, CF2, and CF3 may be disposed or located in the non-emission area NEA and overlap each other, thus functioning as a light shielding component for preventing optical interference between adjacent pixels from occurring. The first, second, and third color filters CF1, CF2, and CF3 each may include color filter material that allows the second color of light converted by the corresponding color conversion layer to selectively pass therethrough. For example, the first color filter CF1 may be a red color filter, the second color filter CF2 may be a green color filter, and the third color filter CF3 may be a blue color filter, but embodiments of the present disclosure are not limited thereto.

An encapsulation layer ENC may be provided and/or formed on the color filter layer CFL.

The encapsulation layer ENC may include a fifth insulating layer INS5. The fifth insulating layer INS5 may be an inorganic insulating layer including inorganic material or an organic insulating layer including organic material. The fifth insulating layer INS5 may cover the entirety of components disposed thereunder and prevent external water or moisture from being drawn into the color filter layer CFL and the display element layer DPL.

In the pixel PXL in accordance with the foregoing embodiment, the color conversion layer CCL and the color filter layer CFL may be disposed on the light emitting elements LD1 and LD2 through successive processes so that light having excellent light reproducibility can be emitted through the color conversion layer CCL and the color filter layer CFL, whereby the light output efficiency may be enhanced.

In one or more embodiments, the fifth insulating layer INS5 may be formed of multiple layers. For example, the fifth insulating layer INS5 may be formed of at least two inorganic insulating layers, and at least one organic insulating layer interposed between the at least two inorganic insulating layers. Here, the constituent material and/or structure of the fifth insulating layer INS5 may be changed in various ways. In one or more embodiments, at least one overcoat layer, at least one filler layer, at least one upper substrate, and/or the like may be further disposed over the fifth insulating layer INS5.

In one or more embodiments, as illustrated in FIG. 28, the color conversion layer CCL and the color filter layer CFL may be formed on one surface of a base layer BSL through successive processes, as illustrated in FIG. 28, thus forming a separate substrate, e.g., an upper substrate U_SUB. The upper substrate U_SUB may be coupled to the display element layer DPL including the first electrode PE1, the intermediate electrodes CTE, the second electrode PE2, and the like through the intermediate layer CTL or the like.

The intermediate layer CTL may be a transparent adhesive layer (or a transparent bonding layer), e.g., an optically clear adhesive layer, for enhancing the adhesive force between the display element layer DPL and the upper substrate U_SUB, but embodiments of the present disclosure are not limited thereto. In one or more embodiments, the intermediate layer CTL may be a refractive index conversion layer configured to change the refractive index of light emitted from the light emitting elements LD toward the upper substrate U_SUB and enhance emission luminance of the pixel PXL. In one or more embodiments, the intermediate layer CTL may include a filler formed of insulating material having insulation property and adhesion property.

The upper substrate U_SUB may include the base layer BSL, the color filter layer CFL, a first capping layer CPL1, the second bank BNK2, the color conversion layer CCL, and a second capping layer CPL2.

The base layer BSL may be a rigid or flexible substrate, and the material or properties thereof are not particularly limited in embodiments. The base layer BSL may be formed of the same material as that of the substrate SUB, or may be formed of material different from that of the substrate SUB.

The color filter layer CFL and the color conversion layer CCL may be disposed on one surface of the base layer BSL to oppose the display element layer DPL. The first color filter CF1 of the color filter layer CFL may be provided on one surface of the base layer BSL to correspond to the color conversion layer CCL in the emission area EMA. The first, second, and third color filters CF1, CF2, and CF3 of the color filter layer CFL may be disposed in the non-emission area NEA and overlap each other, thus functioning as a light shielding component.

The first capping layer CPL1 may be disposed between the color filter layer CFL and the color conversion layer CCL.

The first capping layer CPL1 may be disposed on the color filter layer CFL and cover the color filter layer CFL, thus protecting the color filter layer CFL. The first capping layer CPL1 may be an inorganic layer including inorganic material or an organic layer including organic material.

The second bank BNK2 and the color conversion layer CCL may be disposed on one surface of the first capping layer CPL1.

The second bank BNK2 may be a dam structure that ultimately defines the emission area EMA of the pixel PXL. At the step of supplying the color conversion layer CCL, the second bank BNK2 may be a dam structure that ultimately defines the emission area EMA to which the color conversion layer CCL is to be supplied.

The second capping layer CPL2 may be disposed on the overall surfaces of the second bank BNK2 and the color conversion layer CCL.

The second capping layer CPL2 may include at least one of silicon nitride (SiNₓ), silicon oxide (SiOₓ), silicon oxynitride (SiOₓN_{y}), and metal oxide such as aluminum oxide (AlOₓ), but embodiments of the present disclosure are not limited thereto. In one or more embodiments, the second capping layer CPL2 may be formed of an organic layer including organic material. The second capping layer CPL2 may be disposed on the color conversion layer CCL and protect the color conversion layer CCL from external water or moisture so that the reliability of the color conversion layer CCL can be further enhanced.

The upper substrate U_SUB may be connected with the display element layer DPL by the intermediate layer CTL.

Embodiments can provide a pixel comprising: a substrate including an emission area and a non-emission area; a first conductive pattern, a second conductive pattern, and a third conductive pattern in the non-emission area and spaced from each other; a via layer over the first to the third conductive patterns, and comprising a first contactor exposing one area of the first conductive pattern, a second contactor exposing one area of the second conductive pattern, and a third contactor exposing another area of the second conductive pattern; a first alignment electrode and a second alignment electrode on the via layer, and spaced from each other; a light emitting element between the first alignment electrode and the second alignment electrode; and a first electrode and a second electrode spaced from each other, and electrically connected to the light emitting element, wherein, in at least the non-emission area, at least one of the first and the second electrodes directly contacts the one area of the first conductive pattern through the first contactor, and at least one of the first and the second alignment electrodes directly contacts the one area of the second conductive pattern through the second contactor.

The first conductive pattern, second conductive pattern, and third conductive pattern may each form part of a pixel circuit for the pixel.

The first contactor, second contactor, and third contactor may be formed as contact holes in the via layer.

The via layer may be provided and/or formed on a passivation layer.

The via layer may be an insulating layer.

The passivation layer may be over the first conductive pattern, the second conductive pattern, and the third conductive pattern. The passivation layer may comprise contact holes corresponding (e.g. overlapping with) the first contactor, the second contactor, and the third contactor.

The pixel may further include: at least one transistor located between the substrate and the passivation layer, and electrically connected to the light emitting element; a capacitor between the substrate and the passivation layer, and including a first storage electrode connected to a gate electrode of the transistor, and a second storage electrode electrically connected to the light emitting element; a first power line between the substrate and the passivation layer, and configured to receive a voltage of a first driving power supply; and a second power line spaced from the first power line, and configured to receive a voltage of a second driving power supply different from the first driving power supply.

In one or more embodiments, the first conductive pattern may include the second storage electrode. The second conductive pattern may include the second power line. The third conductive pattern may include the first power line.

In some embodiments, a conductive pattern of a pixel circuit and an electrode of the pixel (e.g. a pixel electrode), for example formed of transparent conductive oxide, may be brought into direct contact with and connected to each other on a connection point (or a node) between a pixel circuit (or a pixel circuit layer) and an emission component (or a display element layer), so that an alignment electrode (e.g. made of aluminum) and the conductive pattern may be prevented being connected to each other, whereby a defect which may occur between the conductive pattern and the alignment electrode may be prevented.

Embodiments can provide a display device comprising: a substrate including a display area, and a non-display area, the non-display area including a pad area; a plurality of pixels in the display area, each of the plurality of pixels being according to any of the discussed embodiments; and a pad in the pad area, and electrically connected with each of the plurality of pixels.

Embodiments can provide a display device comprising: a substrate including a display area, and a non-display area, the non-display area including a pad area; a plurality of pixels in the display area, each of the plurality of pixels including an emission area and a non-emission area; and a pad in the pad area, and electrically connected with each of the plurality of pixels, wherein each of the plurality of pixels comprises: a first conductive pattern, a second conductive pattern, and a third conductive pattern in the non-emission area and spaced from each other; a passivation layer on the first to the third conductive patterns, and including a first contact hole exposing one area of the first conductive pattern, a second contact hole exposing one area of the second conductive pattern, and a third contact hole exposing another area of the second conductive pattern; a via layer on the passivation layer, and comprising a first contactor overlapping the first contact hole, a second contactor overlapping the second contact hole, and a third contactor overlapping the third contact hole; a first alignment electrode and a second alignment electrode on the via layer, and spaced from each other; a first insulating layer on the first and the second alignment electrodes, and including a first through hole corresponding to the first contactor, and a second through hole corresponding to the third contactor; light emitting elements on the first insulating layer between the first alignment electrode and the second alignment electrode; a second insulating layer on the light emitting elements and exposing opposite ends of each of the light emitting elements, and including a first opening overlapping the first through hole and the first contactor, and a second opening overlapping the second through hole and the third contactor; an intermediate electrode on the second insulating layer and electrically connected to the light emitting elements; a third insulating layer on the intermediate electrode, and including a first via hole corresponding to the first opening, and a second via hole corresponding to the second opening; and a first electrode and a second electrode on the third insulating layer at positions spaced from each other, and electrically connected to the light emitting elements.

Embodiments can provide a method of fabricating a display device, comprising: forming a first conductive pattern and a second conductive pattern spaced from each other on a substrate, and forming a passivation layer on the first and the second conductive patterns; forming a via material layer on the passivation layer, the via material layer including a second contactor exposing one area of the passivation layer on the second conductive pattern, and a stepped portion corresponding to the first conductive pattern; exposing a portion of the second conductive pattern by removing the one area of the passivation layer by a dry etching method; forming, on the via material layer, a first alignment electrode and a second alignment electrode spaced from each other; forming, on the first and the second alignment electrodes, a first insulating layer including a first through hole exposing the stepped portion; forming, by removing the stepped portion by an ashing method, a via layer including a first contactor exposing the passivation layer located under the stepped portion; forming a bank on the via layer; aligning light emitting elements on the first insulating layer between the first alignment electrode and the second alignment electrode; forming, on the light emitting elements and the first insulating layer, a second insulating layer configured exposing opposite ends of each of the light emitting elements; forming, on the second insulating layer, an intermediate electrode electrically connected to the light emitting elements; forming, on the intermediate electrode, a third insulating layer covering the intermediate electrode; and forming, on the third insulating layer, a first electrode and a second electrode spaced from each other and electrically connected to the light emitting elements.

In accordance with one or more embodiments of the present disclosure, a conductive pattern of a pixel circuit and a pixel electrode (or an electrode) formed of transparent conductive oxide may be brought into direct contact with and connected to each other on a connection point (or a node) between a pixel circuit (or a pixel circuit layer) and an emission component (or a display element layer), so that an alignment electrode made of aluminum and the conductive pattern can be prevented from being connected to each other, whereby a defect that may occur between the conductive pattern and the alignment electrode can be prevented.

Furthermore, in one or more embodiments of the present disclosure, opposite side surfaces of a via layer disposed on the connection point may be designed to have inclination angles identical with or similar to inclination angles of opposite side surfaces of an insulating layer (or a first insulating layer) disposed over the opposite side surfaces of the via layer, so that the conductive pattern and the pixel electrode can be more reliably connected to each other.

Consequently, embodiments of the present disclosure may provide a pixel having improved reliability, a display device including the pixel, and a method of fabricating the display device.

The aspects, features, and effects of the present disclosure are not limited by the foregoing, and other various aspects, features, and effects are anticipated herein.

While various embodiments have been described above, those skilled in the art will appreciate that various modifications, additions, and substitutions are possible, without departing from the scope of the present disclosure.

Therefore, the embodiments disclosed in this specification are only for illustrative purposes rather than limiting the present disclosure. The scope of the present disclosure must be defined by the accompanying claims.

## Claims

1. A pixel comprising:
a substrate including an emission area and a non-emission area;
a first conductive pattern, a second conductive pattern, and a third conductive pattern in the non-emission area and spaced from each other;
a via layer on the first to the third conductive patterns, and comprising a first contactor exposing one area of the first conductive pattern, a second contactor exposing one area of the second conductive pattern, and a third contactor exposing another area of the second conductive pattern;
a first alignment electrode and a second alignment electrode on the via layer, and spaced from each other;
a light emitting element between the first alignment electrode and the second alignment electrode; and
a first electrode and a second electrode spaced from each other, and electrically connected to the light emitting element,
wherein, in at least the non-emission area, at least one of the first and the second electrodes directly contacts the one area of the first conductive pattern through the first contactor, and at least one of the first and the second alignment electrodes directly contacts the one area of the second conductive pattern through the second contactor.

2. The pixel according to claim 1, further comprising:
a passivation layer between the via layer and the first and second conductive patterns;
a first insulating layer between the light emitting element and the first and the second alignment electrodes;
a second insulating layer on the light emitting element, and exposing first and second ends of the light emitting element; and
a third insulating layer on the second insulating layer,
wherein the first insulating layer includes a first through hole corresponding to the first contactor, and a second through hole corresponding to the third contactor.

3. The pixel according to claim 2,
wherein an inclination angle of each of opposite side surfaces of the via layer that oppose each other with the first contactor located therebetween is same as an inclination angle of each of opposite side surfaces of the first insulating layer that oppose each other with the first through hole located therebetween, and
wherein an inclination angle of each of opposite side surfaces of the via layer that oppose each other with the third contactor located therebetween is same as an inclination angle of each of opposite side surfaces of the first insulating layer that oppose each other with the second through hole located therebetween.

4. The pixel according to claim 2 or 3,
wherein the passivation layer includes a first contact hole overlapping the first contactor and exposing the one area of the first conductive pattern, a second contact hole overlapping the second contactor and exposing the one area of the second conductive pattern, and a third contact hole overlapping the third contactor and exposing the another area of the second conductive pattern,
wherein the second insulating layer includes a first opening corresponding to the first contact hole, and a second opening corresponding to the third contact hole, and
wherein the third insulating layer includes a first via hole corresponding to the first opening, and a second via hole corresponding to the second opening.

5. The pixel according to claim 4,
wherein the first electrode directly contacts the one area of the first conductive pattern through the first via hole of the third insulating layer, the first opening of the second insulating layer, the first through hole of the first insulating layer, the first contactor of the via layer, and the first contact hole of the passivation layer, and
wherein the second alignment electrode directly contacts the one area of the second conductive pattern through the second contactor of the via layer and the second contact hole of the passivation layer.

6. The pixel according to claim 5, further comprising:
at least one transistor located between the substrate and the passivation layer, and electrically connected to the light emitting element;
a capacitor between the substrate and the passivation layer, and including a first storage electrode connected to a gate electrode of the transistor, and a second storage electrode electrically connected to the light emitting element;
a first power line between the substrate and the passivation layer, and configured to receive a voltage of a first driving power supply; and
a second power line spaced from the first power line, and configured to receive a voltage of a second driving power supply different from the first driving power supply.

7. The pixel according to claim 6,
wherein the first conductive pattern comprises the second storage electrode, and
wherein the second conductive pattern comprises the second power line.

8. The pixel according to claim 7,
wherein the via layer further comprises a fourth contactor exposing one area of the third conductive pattern, and
wherein the passivation layer further includes a fourth contact hole corresponding to the fourth contactor and exposing the one area of the third conductive pattern.

9. The pixel according to claim 8,
wherein the second electrode directly contacts the another area of the second conductive pattern through the second via hole of the third insulating layer, the second opening of the second insulating layer, the second through hole of the first insulating layer, the third contactor of the via layer, and the third contact hole of the passivation layer, and
wherein the first alignment electrode directly contacts the one area of the third conductive pattern through the fourth contactor of the via layer and the fourth contact hole of the passivation layer;
optionally wherein the third conductive pattern comprises the first power line.

10. The pixel according to claim 9, further comprising a first bank in the non-emission area, and including an opening corresponding to the emission area,
wherein the second and the fourth contactors of the via layer overlap the first bank, and the first and the third contactors of the via layer do not overlap the first bank;
optionally further comprising an intermediate electrode spaced from the first and the second electrodes;
optionally wherein the light emitting element comprises: a first light emitting element between a first side of the first alignment electrode and the second alignment electrode, and comprising a first end electrically connected to the first electrode, and a second end electrically connected to the intermediate electrode; and a second light emitting element between a second side of the first alignment electrode and the second alignment electrode, and including a first end electrically connected to the intermediate electrode, and a second end electrically connected to the second electrode;
optionally further comprising: a second bank on the first bank in the non-emission area; a color conversion layer over the first and the second light emitting elements in the emission area, and configured to convert a first color of light emitted from the first and the second light emitting elements to a second color of light; and a color filter on the color conversion layer and configured to allow the second color of light to selectively pass therethrough.

11. The pixel according to claim 10,
wherein the opposite side surfaces of the via layer that oppose each other with the first contactor located therebetween is located more inside of the substrate than the opposite side surfaces of the first insulating layer that oppose each other with the first through hole located therebetween, and
wherein the opposite side surfaces of the via layer and the opposite side surfaces of the first insulating layer are covered by the first bank.

12. A display device comprising:
a substrate including a display area, and a non-display area, the non-display area including a pad area;
a plurality of pixels in the display area, each of the plurality of pixels including an emission area and a non-emission area; and
a pad in the pad area, and electrically connected with each of the plurality of pixels,
wherein each of the plurality of pixels comprises:
a first conductive pattern, a second conductive pattern, and a third conductive pattern in the non-emission area and spaced from each other;
a passivation layer on the first to the third conductive patterns, and including a first contact hole exposing one area of the first conductive pattern, a second contact hole exposing one area of the second conductive pattern, and a third contact hole exposing another area of the second conductive pattern;
a via layer on the passivation layer, and comprising a first contactor overlapping the first contact hole, a second contactor overlapping the second contact hole, and a third contactor overlapping the third contact hole;
a first alignment electrode and a second alignment electrode on the via layer, and spaced from each other;
a first insulating layer on the first and the second alignment electrodes, and including a first through hole corresponding to the first contactor, and a second through hole corresponding to the third contactor;
light emitting elements on the first insulating layer between the first alignment electrode and the second alignment electrode;
a second insulating layer on the light emitting elements and exposing opposite ends of each of the light emitting elements, and including a first opening overlapping the first through hole and the first contactor, and a second opening overlapping the second through hole and the third contactor;
an intermediate electrode on the second insulating layer and electrically connected to the light emitting elements;
a third insulating layer on the intermediate electrode, and including a first via hole corresponding to the first opening, and a second via hole corresponding to the second opening; and
a first electrode and a second electrode on the third insulating layer at positions spaced from each other, and electrically connected to the light emitting elements.

13. The display device according to claim 12,
wherein, in at least the non-emission area, the first electrode directly contacts the one area of the first conductive pattern through the first via hole, the first opening, the first through hole, the first contactor, and the first contact hole, and
wherein, in at least the non-emission area, the second alignment electrode directly contacts the one area of the second conductive pattern through the second contactor and the second contact hole.

14. The display device according to claim 12 or 13, wherein the pad comprises: a first pad electrode disposed on the substrate; the passivation layer on the first pad electrode, and including a first pad electrode contact hole exposing one area of the first pad electrode; the third insulating layer on the passivation layer, and including a second pad electrode contact hole corresponding to the first pad electrode contact hole; and a second pad electrode on the third insulating layer, and directly contacting the first pad electrode through the first pad electrode contact hole and the second pad electrode contact hole, wherein the first pad electrode is provided at a same layer as the first to the third conductive patterns, and comprises a same material as the first to the third conductive patterns, and wherein the second pad electrode is at a same layer as the first and the second electrodes, and comprises a same material as the first and the second electrodes; or
wherein the pad comprises: a first pad electrode on the substrate; the passivation layer on the first pad electrode, and including a first pad electrode contact hole exposing one area of the first pad electrode; the second insulating layer on the passivation layer, and including a second pad electrode contact hole corresponding to the first pad electrode contact hole; a second pad electrode on the first insulating layer, and directly contacting the first pad electrode through the first pad electrode contact hole and the second pad electrode contact hole; and the third insulating layer on the second pad electrode, and including a third pad electrode contact hole exposing one area of the second pad electrode, wherein the first pad electrode is at a same layer as the first to the third conductive patterns, and comprises a same material as the first to the third conductive patterns, and wherein the second pad electrode is provided at a same layer as the intermediate electrode, and comprises a same material as the intermediate electrode.

15. A method of fabricating a display device, comprising:
forming a first conductive pattern and a second conductive pattern spaced from each other on a substrate, and forming a passivation layer on the first and the second conductive patterns;
forming a via material layer on the passivation layer, the via material layer including a second contactor exposing one area of the passivation layer on the second conductive pattern, and a stepped portion corresponding to the first conductive pattern;
exposing a portion of the second conductive pattern by removing the one area of the passivation layer by a dry etching method;
forming, on the via material layer, a first alignment electrode and a second alignment electrode spaced from each other;
forming, on the first and the second alignment electrodes, a first insulating layer including a first through hole exposing the stepped portion;
forming, by removing the stepped portion by an ashing method, a via layer including a first contactor exposing the passivation layer located under the stepped portion;
forming a bank on the via layer;
aligning light emitting elements on the first insulating layer between the first alignment electrode and the second alignment electrode;
forming, on the light emitting elements and the first insulating layer, a second insulating layer configured exposing opposite ends of each of the light emitting elements;
forming, on the second insulating layer, an intermediate electrode electrically connected to the light emitting elements;
forming, on the intermediate electrode, a third insulating layer covering the intermediate electrode; and
forming, on the third insulating layer, a first electrode and a second electrode spaced from each other and electrically connected to the light emitting elements.
